# EUROPÄISCHE PATENTSCHRIFT

(11) **EP 3 117 907 B1**
(45) Veröffentlichungstag und Bekanntmachung des Hinweises auf die Patenterteilung: **25.10.2017**
(21) Anmeldenummer: 15176519.5
(22) Anmeldetag: 13.07.2015
(51) Int. Cl.: B05D 1/00, C23C 14/20, C23C 14/16, C23C 14/58, C23C 14/02, C23C 16/50, C23C 28/00, B05D 3/00, B05D 3/14

(54) **VERFAHREN ZUR HERSTELLUNG BESCHICHTETER SUBSTRATE**
METHOD FOR THE PRODUCTION OF COATED SUBSTRATES
PROCEDE DE FABRICATION DE SUBSTRAT REVETU

(43) Veröffentlichungstag der Anmeldung: 18.01.2017
(60) Teilanmeldung: 16160981.3
(73) Patentinhaber: HEC High End Coating GmbH, 35108 Allendorf (Eder) (DE)
(72) Erfinder: Koch, Matthias, 59969 Bromskirchen (DE)
(74) Vertreter: Metten, Karl-Heinz

(56) Entgegenhaltungen:
- EP-A1- 0 306 612
- EP-A1- 0 349 749
- EP-A1- 1 174 526
- EP-A1- 2 752 504
- US-A1- 2002 142 104
- US-A1- 2014 295 141
- US-B1- 6 268 060

## Beschreibung

Die vorliegende Erfindung betrifft Verfahren zur Herstellung beschichteter Substrate.

Metallische wie nicht-metallische Bauteile werden häufig zur Erzeugung einer glatten und/oder glänzenden Oberfläche beschichtet. In der Regel handelt es sich hierbei um mehrlagige Beschichtungssysteme. Neben dem Wunsch, eine Oberfläche mit hochwertiger Anmutung zu erhalten, wird mit derartigen Beschichtungssystemen regelmäßig auch ein ausgeprägter Korrosionsschutz angestrebt. Ein dauerhafter Korrosionsschutz wird nicht selten durch mechanische Beschädigung zunichte gemacht. Vielfach setzt bereits bei geringfügigsten mechanischen Beschädigungen beschichteter Oberflächen Korrosion ein. Dies kann neben Verfärbungen auch Unterwanderungsphänomene zur Folge haben. Nicht selten führt dies dann zum Abplatzen von Beschichtungsarealen. Es hat nicht an Versuchen gefehlt, beschichtete glänzende Oberflächen korrosionsbeständig auszustatten. Beispielsweise beschreibt die DE 123 765 A1 ein Verfahren zur Erzeugung einer Korrosionsschutzschicht auf einer metallischen Oberfläche, bei dem ein auf Siliziumverbindungen basierendes Sol, ein Aminoalkyl-funktionalisiertes Alkoxysilan oder ein Umsetzungsprodukt der beiden vorangehend genannten Komponenten zum Einsatz kommt.

Gemäß der DE 38 33 119 C2 erhält man eine sehr gut auf einem Substrat haftende korrosionsgeschützte chromatierte Metalloberfläche dadurch, dass ein Elektrotauchlack direkt auf die Chromatierschicht ohne Zwischentrocknung abgeschieden wird.

Die EP 2 752 504 betrifft ein Verfahren zur Herstellung eines metallischen oder nicht-metallischen metallisch beschichteten Substrats, umfassend die Schritte: a) Zurverfügungstellung mindestens eines Substrats mit mindestens einer zumindest bereichsweise metallisch beschichtbaren Oberfläche; c) Aufbringen mindestens einer metallischen Kompositschutzschicht, enthaltend als Hauptkomponente mindestens ein erstes Metall ausgewählt aus der Gruppe, bestehend aus Aluminium, Mangan, Magnesium und Zink, oder mindestens eine erste Metalllegierung ausgewählt aus der Gruppe, bestehend aus Stahl, Edelstahl, einer Magnesiumlegierung und einer Aluminiumlegierung, und in der Hauptkomponente verteilt vorliegend als Minderkomponente mindestens ein zweites Metall und/oder mindestens ein oxydisch gebundenes zweites Metall, ausgewählt aus der Gruppe, bestehend aus Zirkonium, Titan und Hafnium, oder bestehend aus der Hauptkomponente und der Minderkomponente, wobei der Verfahrensschritt c) die Teilschritte umfasst: i) Aufbringen mindestens einer Metallschicht enthaltend das oder bestehend aus dem mindestens einen ersten Metall oder enthaltend die oder bestehend aus der mindestens einen ersten Metalllegierung mittels Aufdampf- und/oder Sputter-Technik auf der beschichtbaren Oberfläche des Substrats und ii) Behandeln der Metallschicht gemäß Schritt i) mit mindestens einem ersten wässrigen System, enthaltend mindestens eine erste Verbindung des zweiten Metalls; d) Silanisieren der Kompositschutzschicht aus Schritt c) ii) durch Behandeln mit mindestens einem zweiten wässrigen System unter Ausbildung mindestens einer Polysiloxanschicht; und e) Aufbringen mindestens einer Lackschicht auf der Polysiloxanschicht gemäß Schritt d). Mit diesem Verfahren soll man zu beschichteten Substraten gelangen, die bei mechanischer Beanspruchung oder Beschädigung über einen langen Zeitraum korrosionsbeständig sind, die sich durch eine gute Haftung sämtlicher Schichten auszeichnen und die eine ansprechende Optik behalten sowie keine Ablaufspuren oder Schlieren zeigen.

Aus der EP 1 174 526 geht ein Verfahren zum Aufgedampften mehrerer unterschiedlicher Metalldämpfe wie Zinkdampf und Magnesiumdampf auf Stahlsubstrate unter sogenannten gedrosselten Bedingungen hervor, wobei die unterschiedlichen Metalldämpfe vor der Auftragung auch miteinander vermengt werden können. Indem man die Auftragung unter gedrosselten Bedingungen vornimmt, sollen sich zwei oder mehr unterschiedliche Metalldämpfe problemlos auf einer Substratoberfläche abscheiden lassen.

Die EP 306 612 beschreibt ein Verfahren zur Aufbringung von Schichten auf Substraten, wobei in einer Vakuumkammer Schichtmaterial mittels wenigstens zweier verschiedener Einrichtungen in den gasförmigen Zustand übergeführt und auf den Substraten unter Bildung einer Schicht niedergeschlagen wird. Hierbei wird zur Überführung eines Teiles des Materials in Dampfform eine magnetfeldunterstützte Kathodenzerstäubung vorgenommen und die Überführung eines anderen Teils des Materials mittels einer elektrischen Bogenentladung bewirkt. Im zeitlichen Mittel haben dabei wenigstens fünf Atomprozente des auf die Funktionsflächen der Substrate aufzubringenden Metallanteiles aus der Überführung von Elektrodenmaterial der Bogenentladung in die Dampfform herzurühren. Mit diesem Verfahren soll es möglich sein, kompaktere, dichtere Schichten herzustellen, als dies bisher mittels Kathodenzerstäubung gelingt.

In der US 2014/295141 wird ein Beschichtungsverfahren beschrieben, umfassend die Schritte des Auftragens einer Aluminiumschicht mittels Verdampfung auf einer Oberfläche eines Gegenstands aus einem semikristallinen Polymer und des Auftragens einer Hexamethyldisiloxanschicht, ebenfalls mittels Verdampfung, in einer Weise, dass nach Erhitzung des beschichteten Gegenstands auf einen Temperaturbereich von 165°C bis 190 °C über einen Zeitraum zwischen einer und vier Stunden eine Aluminiumschicht mit einer Dicke kleiner 200 nm und eine Schicht auf Basis von Hexamethyldisiloxan mit einer Dicke kleiner 325 nm resultierten. Die derart erhaltene Oberflächen soll frei von Linien sein und sich durch eine diffuse Reflexion nicht oberhalb von 2 % auszeichnen, gemessen bei 600 nm gemäß ASTM C1650-07. Das geschilderte Resultat wird dabei nur dann erhalten, wenn ein Aluminiumtarget mit einer Leistungsdichte von 40 W/cm² für eine Dauer von maximal zwei Minuten gesputtert und der zu beschichtende Gegenstand zwischen zwei- und 25-mal vor dem Aluminiumtarget vorbeigeführt wird. Anschließend ist gasförmiges Hexamethyldisiloxan für einen Zeitraum zwischen 1 und 20 Sekunden bei einem Druck von 20 bis 75 mTorr an dem zu beschichtenden Gegenstand vorbeizuleiten. Während des Vorbeileitens von Hexamethyldisiloxan ist dieses einer Leistungsdichte im Bereich zwischen 0,5 W/cm² und 3 W/cm² für einen Zeitraum zwischen 0,2 und 3,3 Minuten auszusetzen. Dieser Vorgang kann 40-mal wiederholt werden.

Korrosionsschutzbeschichtungen für Metallsubstrate zeigen jedoch noch stets erhebliches Verbesserungspotential in Sachen Haftung und Korrosionsschutz, insbesondere bei massengefertigten Produkten, vor allem solchen mit anspruchsvoller Geometrie.

Der vorliegenden Erfindung lag daher die Aufgabe zu Grunde, beschichtete Substrate zur Verfügung zu stellen, die nicht mehr mit den Nachteilen des Stands der Technik behaftetet sind und die insbesondere auch in der Massenfertigung beschichtete Produkte mit verbessertem Korrosionsschutz und/oder sehr guten Haftungseigenschaften liefern. Es werden auch solche beschichteten Produkte angestrebt, die bei mechanischer Oberflächenbeschädigung nicht sogleich Unterwanderungsphänomene zeigen, insbesondere auch nicht verbunden mit dem Abblättern von Schichten. Des Weiteren lag der Erfindung die Aufgabe zugrunde, zu beschichteten Substraten zu gelangen, die selbst mit komplexer Geometrie über das gesamte Bauteil, einschließlich im Bereich von Kantenverläufen, ein gleichwertig hohes Beschichtungsergebnis zeigen.

Demgemäß wurde ein Verfahren zur Herstellung eines beschichteten nicht-metallischen Substrats, insbesondere Kunststoffsubstrats, gefunden, umfassend
a) Zurverfügungstellung eines nicht-metallischen Substrats, insbesondere Kunststoffsubstrats, mit mindestens einer zumindest bereichsweise beschichtbaren Oberfläche,
b) Zurverfügungstellung einer Applikationsanlage für die Aufbringung einer Metallschicht, insbesondere Vakuumaufdampfanlage oder Sputter-Anlage,
c) Zurverfügungstellung mindestens eines Plasmagenerators und/oder mindestens einer Corona-Anlage, insbesondere in der Applikationsanlage für die Aufbringung einer Metallschicht, wie Vakuumaufdampfanlage oder Sputter-Anlage, oder als Bestandteil hiervon,
d) gegebenenfalls Plasmabehandlung mit dem Plasmagenerator und/oder Corona-Behandlung des nicht-metallischen Substrats, insbesondere Kunststoffsubstrats, oder der beschichtbaren Oberfläche des nicht-metallischen Substrats, insbesondere Kunststoffsubstrats,
e) gegebenenfalls Behandeln des nach Schritt a) oder d) erhaltenen nicht-metallischen Substrats, insbesondere Kunststoffsubstrats, oder der beschichtbaren Oberflächen des nicht-metallischen Substrats, insbesondere Kunststoffsubstrats, mit mindestens einer siliziumorganischen Verbindung, insbesondere mittels Plasmapolymerisation, unter Ausbildung einer Polysiloxanschicht,
f) gegebenenfalls Plasmabehandlung mit dem Plasmagenerator und/oder Corona-Behandlung der Polysiloxanschicht gemäß Schritt e),
g) gegebenenfalls Aufbringen mindestens einer Grundierungsschicht auf das nicht-metallische Substrat, insbesondere Kunststoffsubstrat, oder die beschichtbare Oberfläche des nicht-metallischen Substrats, insbesondere Kunststoffsubstrats, gemäß Schritt a) oder d) oder auf die Polysiloxanschicht gemäß Schritt e) oder f),
h) gegebenenfalls Plasmabehandlung mit dem Plasmagenerator und/oder Corona-Behandlung der Grundierungsschicht gemäß Schritt g),
i) gegebenenfalls Behandeln der nach Schritt g) oder h) erhaltenen Grundierungsschicht mit mindestens einer siliziumorganischen Verbindung, insbesondere mittels Plasmapolymerisation, unter Ausbildung einer Polysiloxanschicht,
j) gegebenenfalls Plasmabehandlung mit dem Plasmagenerator und/oder Corona-Behandlung der Polysiloxanschicht gemäß Schritt i),
k) Aufbringen mindestens einer Metallschicht, enthaltend oder bestehend aus einem ersten Metall ausgewählt aus der Gruppe bestehend aus Aluminium, Silber, Gold, Blei, Vanadium, Mangan, Magnesium, Eisen, Kobalt, Nickel, Kupfer, Chrom, Palladium, Molybdän, Wolfram, Platin, Titan, Zirkonium und Zink, insbesondere Aluminium, oder enthaltend oder bestehend aus einer ersten Metalllegierung ausgewählt aus der Gruppe bestehend aus Messing, Bronze, Stahl, insbesondere Edelstahl, Aluminium-, Magnesium- und Titanlegiemngen, mit der Applikationsanlage, insbesondere mittels Aufdampf- und/oder Sputter-Technik, auf das nicht-metallische Substrat, insbesondere Kunststoffsubstrat, oder auf die beschichtbaren Oberfläche des nicht-metallischen Substrats, insbesondere Kunststoffsubstrats, gemäß Schritt a) oder d) oder auf die Polysiloxanschicht gemäß Schritt e) oder f) oder auf die Grundierungsschicht gemäß Schritt g) oder h) oder auf die Polysiloxanschicht gemäß Schritt i) oder j),
l) gegebenenfalls Plasmabehandlung mit dem Plasmagenerator und/oder Corona-Behandlung der Metallschicht gemäß Schritt k),
m) Behandeln der nach Schritt k) oder 1) erhaltenen Metallschicht, mit mindestens einer siliziumorganischen Verbindung, insbesondere mittels Plasmapolymerisation, unter Ausbildung einer Polysiloxanschicht,
n) Plasmabehandlung mit dem Plasmagenerator und/oder Corona-Behandlung der Polysiloxanschicht gemäß Schritt m) und
o) Auftragen einer, insbesondere transparenten, Deckschicht auf die behandelte Polysiloxanschicht gemäß Schritt n).

Die der Erfindung zu Grunde liegende Aufgabe wird dabei insbesondere auch durch ein solches Verfahren gelöst, umfassend die Schritte
a) Zurverfügungstellung eines nicht-metallischen Substrats, insbesondere Kunststoffsubstrats, mit mindestens einer zumindest bereichsweise beschichtbaren Oberfläche,
b) Zurverfügungstellung einer Applikationsanlage für die Aufbringung einer Metallschicht, insbesondere Vakuumaufdampfanlage oder Sputter-Anlage,
c) Zurverfügungstellung mindestens eines Plasmagenerator und/oder mindestens einer Corona-Anlage, insbesondere in der Applikationsanlage für die Aufbringung einer Metallschicht, wie Vakuumaufdampfanlage oder Sputter-Anlage, oder als Bestandteil hiervon,
d) gegebenenfalls Plasmabehandlung mit dem Plasmagenerator und/oder Corona-Behandlung des nicht-metallischen Substrats, insbesondere Kunststoffsubstrats, oder der beschichtbaren Oberfläche des nicht-metallischen Substrats, insbesondere Kunststoffsubstrats,
e) gegebenenfalls Behandeln des nach Schritt a) oder d) erhaltenen nicht-metallischen Substrats, insbesondere Kunststoffsubstrats, oder der beschichtbaren Oberfläche des nicht-metallischen Substrats, insbesondere Kunststoffsubstrats, mit mindestens einer siliziumorganischen Verbindung, insbesondere mittels Plasmapolymerisation, unter Ausbildung einer Polysiloxanschicht,
f) gegebenenfalls Plasmabehandlung mit dem Plasmagenerator und/oder Corona-Behandlung der Polysiloxanschicht gemäß Schritt e),
g) Aufbringen mindestens einer Grundierungsschicht auf das nicht-metallische Substrat, insbesondere Kunststoffsubstrat, oder die beschichtbaren Oberfläche des nicht-metallischen Substrats, insbesondere Kunststoffsubstrats, gemäß Schritt a) oder d) oder auf die Polysiloxanschicht gemäß Schritt e) oder f),
h) Plasmabehandlung mit dem Plasmagenerator und/oder Corona-Behandlung der Grundierungsschicht gemäß Schritt g),
i) gegebenenfalls Behandeln der nach Schritt g) oder h) erhaltenen Grundierungsschicht mit mindestens einer siliziumorganischen Verbindung, insbesondere mittels Plasmapolymerisation, unter Ausbildung einer Polysiloxanschicht,
k) Aufbringen mindestens einer Metallschicht, enthaltend oder bestehend aus einem ersten Metall ausgewählt aus der Gruppe bestehend aus Aluminium, Silber, Gold, Blei, Vanadium, Mangan, Magnesium, Eisen, Kobalt, Nickel, Kupfer, Chrom, Palladium, Molybdän, Wolfram, Platin, Titan, Zirkonium und Zink, insbesondere Aluminium, oder enthaltend oder bestehend aus einer ersten Metalllegierung ausgewählt aus der Gruppe bestehend aus Messing, Bronze, Stahl, insbesondere Edelstahl, Aluminium-, Magnesium- und Titanlegierungen, mit der Applikationsanlage, insbesondere mittels Aufdampf- und/oder Sputter-Technik, auf die Grundierungsschicht gemäß Schritt g) oder h) oder auf die Polysiloxanschicht gemäß Schritt i),
m) Behandeln der nach Schritt k) erhaltenen Metallschicht mit mindestens einer siliziumorganischen Verbindung, insbesondere mittels Plasmapolymerisation, unter Ausbildung einer Polysiloxanschicht,
n) Plasmabehandlung mit dem Plasmagenerator und/oder Corona-Behandlung der Polysiloxanschicht gemäß Schritt m) und
o) Auftragen einer, insbesondere transparenten, Deckschicht auf die behandelte Polysiloxanschicht gemäß Schritt n).

Bei dieser Verfahrensvariante sind die Schritte d), e) und f) nur optional. Sie können in Einzelfällen zu einer verbesserten Haftung und einem erhöhten Korrosionsschutz beitragen. Das gleiche trifft auf den optionalen Schritt i) zu. Es hat sich für einige Anwendungen gezeigt, dass es von Vorteil ist, wenn beidseitig der Metallschicht eine, insbesondere plasmagenerierte, Polysiloxanschicht vorliegt, die vorzugsweise jeweils einer Plasmabehandlung und/oder einer Corona-Behandlung, insbesondere Plasmabehandlung, unterzogen wurde.

Die vorangehend geschilderte Verfahrensvariante umfassend die Aufbringung einer Grundierungsschicht bietet sich insbesondere bei nicht-metallischen Substraten, insbesondere Kunststoffsubstraten, mit einer Oberflächen an, die Unebenheiten aufweist bzw. die von minderer Qualität ist.

Für viele Anwendungen hat sich jedoch ein solches Verfahren als völlig ausreichend erwiesen, um die der Erfindung zugrunde liegenden Aufgaben zu lösen, das neben den Verfährensschritten a), b) und c) auch die Verfahrensschritte d), e), f), k), m), n) und o) bzw. k), m), n) und o) als zwingende Verfahrensschritte umfasst, wobei in einer bevorzugten Ausführungsform jeweils vor dem Schritt der Aufbringung der Metallschicht k) die Aufbringung einer, insbesondere plasmagenerierten, Polysiloxanschicht (Schritt i)) vorgesehen werden kann. Die vorangehend geschilderte Verfahrensvariante kann insbesondere bei einwandfreien nicht-metallischen Substraten, insbesondere Kunststoffsubstraten mit einwandfreier bzw. glatter Oberfläche eingesetzt werden.

Ferner kann in einer Weiterentwicklung des erfindungsgemäßen Verfahrens für die Herstellung nicht-metallischer Substrate, insbesondere von Kunststoffsubstraten, Gebrauch gemacht werden von der Einhaltung der Schrittfolge d), e), f), g), k), m), n) und o) bzw. g), k), m), n) und o), d.h. unter Weglassung der Behandlung bzw. Aktivierung der Grundierungsschicht mit einem Plasma (Schritt h)). Gleichwohl kann hier auch der Schritt h) zur Anwendung kommen. Auch hier kann es von Vorteil sein, vor dem Schritt der Aufbringung der Metallschicht k) eine, insbesondere plasmagenerierte, Polysiloxanschicht aufzutragen (Schritt i)). Ferner kann in einer Ausgestaltung neben den Verfahrensschritten a), b) und c) von der Abfolge der Verfahrensschritte d), e), f), g), h), k), m), n) und o) oder der Verfahrensschritte d), i), j), k), m), n) und o) Gebrauch gemacht werden.

In einer besonders zweckmäßigen Ausgestaltung, insbesondere wie vorangehend spezifiziert, wird die Schicht, auf die die Metallschicht gemäß Schritt k) aufgebracht wird, vor dem Schritt k) einer Plasmabehandlung mit dem Plasmagenerator und/oder einer Corona-Behandlung unterzogen (beispielsweise Schritte j), f) oder d)).

Es hat sich als vorteilhaft erwiesen, die vorangehend genannten Verfahrensschritte im Wesentlichen unmittelbar aufeinanderfolgen zu lassen. Dies bedeutet insbesondere, dass nach den Plasmabehandlungsschritten eine längere Lagerung vermieden werden sollte. Vielmehr ist es von Vorteil, wenn der nachfolgende Verfahrensschritt direkt folgt. Auch hat sich gezeigt, dass neben den vorangehend genannten Verfahrensschritten es nicht erforderlich ist, weitere Verfahrensschritte zwischenzuschalten.

Auch hat es sich in einer bevorzugten Ausführungsform als günstig insbesondere in Bezug auf gute Haftung und Korrosionsschutz erwiesen, wenn das nicht-metallische Substrat, insbesondere das Kunststoffsubstrat, einer Plasmabehandlung und/oder Corona-Behandlung, insbesondere Plasmabehandlung, unterzogen wird (Schritt d)).

Geeignete nicht-metallische Substrate umfassen Glas, Keramik, Verbundfasermaterialien, Carbonmaterialien, Kunststoff oder Holz. Besonders gut geeignet ist das hier geschilderte erfindungsgemäße Verfahren für die Beschichtung von Kunststoffsubstraten zwecks Erhalts dauerhaft hochglänzender Produkte. Geeignete Kunststoffsubstrate umfassen oder bestehen z.B. aus PVC, Polyurethanen, Polyacrylaten, Polyestern, z.B. PBT und PET, Polyolefinen, insbesondere Polypropylen, Polycarbonaten, Polyamiden, Polyphenylenethem, Polystyrol, Styrol(co)polymere, wie ABS, SAN, ASA oder MABS, Polyoxyalkylene, z.B. POM, Teflon und Polymerblends, insbesondere ABS/PPE-, ASA/PPE-, SAN/PPE- und/oder ABS/PC-Blends.

Die der Erfindung zu Grunde liegende Aufgabe wird des Weiteren gelöst durch ein Verfahren zur Herstellung eines beschichteten Metallsubstrats, umfassend
A) Zurverfügungstellung eines Metallsubstrats mit mindestens einer zumindest bereichsweise beschichtbaren Oberfläche,
B) Zurverfügungstellung einer Applikationsanlage für die Aufbringung einer Metallschicht, insbesondere Vakuumaufdampfanlage,
C) Zurverfügungstellung mindestens eines Plasmagenerator und/oder mindestens einer Corona-Anlage, insbesondere in der Applikationsanlage für die Aufbringung einer Metallschicht, wie Vakuumaufdampfanlage oder der Sputter-Anlage, oder als Bestandteil hiervon,
D) gegebenenfalls Reinigung des Metallsubstrats oder der beschichtbaren Oberfläche des Metallsubstrats,
E) gegebenenfalls Aufbringen mindestens einer Metallschicht, enthaltend oder bestehend aus einem zweiten Metall ausgewählt aus der Gruppe bestehend aus Titan, Hafnium und Zirkonium, insbesondere Zirkonium, oder aus einer zweiten Metalllegierung ausgewählt aus der Gruppe bestehend aus Titan-, Hafnium- und Zirkoniumlegierungen, mit der Applikationsanlage, insbesondere mittels Aufdampf- und/oder Sputter-Technik, auf das Metallsubstrat oder die beschichtbare Oberfläche des Metallsubstrats gemäß Schritt A) oder D),
F) gegebenenfalls Plasmabehandlung mit dem Plasmagenerator und/oder Corona-Behandlung des Metallsubstrats oder der beschichtbaren Oberfläche des Metallsubstrats gemäß Schritt A) oder D) oder der Metallschicht gemäß Schritt E),
G) gegebenenfalls Behandeln des nach Schritt A) oder D) erhaltenen Metallsubstrats oder Behandeln der nach Schritt A) oder D) erhaltenen beschichtbaren Oberfläche des Metallsubstrats oder der nach Schritt E) oder F) erhaltenen Metallschicht mit mindestens einer siliziumorganischen Verbindung, insbesondere mittels Plasmapolymerisation, unter Ausbildung einer Polysiloxanschicht,
H) gegebenenfalls Plasmabehandlung mit dem Plasmagenerator und/oder Corona-Behandlung der Polysiloxanschicht gemäß Schritt G),
I) gegebenenfalls Aufbringen einer Konversionsschicht auf das Metallsubstrat oder die beschichtbare Oberflächen des Metallsubstrats gemäß Schritt A) oder D) oder auf die Metallschicht gemäß Schritt E) oder F) oder auf die Polysiloxanschicht gemäß Schritt G) oder H),
J) gegebenenfalls Plasmabehandlung mit dem Plasmagenerator und/oder Corona-Behandlung der Konversionsschicht gemäß Schritt I),
K) gegebenenfalls Behandeln der nach Schritt I) oder J) erhaltenen Konversionsschicht mit mindestens einer siliziumorganischen Verbindung, insbesondere mittels Plasmapolymerisation, unter Ausbildung einer Polysiloxanschicht,
L) gegebenenfalls Plasmabehandlung mit dem Plasmagenerator und/oder Corona-Behandlung der nach Schritt K) erhaltenen behandelten Polysiloxanschicht,
M) gegebenenfalls Aufbringen mindestens einer Grundierungsschicht auf das Metallsubstrat oder die beschichtbare Oberfläche des Metallsubstrats gemäß Schritt A) oder D) oder auf die Metallschicht gemäß Schritt E) oder F) oder auf die Polysiloxanschicht gemäß Schritt G) oder H) oder auf die Konversionsschicht gemäß Schritt I) oder J) oder auf die Polysiloxanschicht gemäß Schritt K) oder L),
N) gegebenenfalls Plasmabehandlung mit dem Plasmagenerator und/oder Corona-Behandlung der Grundierungsschicht gemäß Schritt M),
O) gegebenenfalls Behandeln der nach Schritt M) oder N) erhaltenen Grundierungsschicht mit mindestens einer siliziumorganischen Verbindung, insbesondere mittels Plasmapolymerisation, unter Ausbildung einer Polysiloxanschicht,
P) gegebenenfalls Plasmabehandlung mit dem Plasmagenerator und/oder Corona-Behandlung der nach Schritt O) erhaltenen behandelten Polysiloxanschicht,
Q) Aufbringen mindestens einer Metallschicht, enthaltend oder bestehend aus einem ersten Metall ausgewählt aus der Gruppe bestehend aus Aluminium, Silber, Gold, Blei, Vanadium, Mangan, Magnesium, Eisen, Kobalt, Molybdän, Wolfram, Nickel, Kupfer, Chrom, Palladium, Platin, Titan, Zirkonium und Zink, insbesondere Aluminium, oder enthaltend oder bestehend aus einer ersten Metalllegierung ausgewählt aus der Gruppe bestehend aus Messing, Bronze, Stahl, insbesondere Edelstahl, Aluminium-, Magnesium- und Titanlegierungen, mit der Applikationsanlage, insbesondere mittels Aufdampf- und/oder Sputter-Technik, auf das Metallsubstrat oder die beschichtbaren Oberfläche des Metallsubstrats gemäß Schritt A) oder D) oder F) auf oder die Polysiloxanschicht gemäß Schritt G) oder H) oder auf die Konversionsschicht gemäß Schritt I) oder J) oder auf die Polysiloxanschicht gemäß Schritt K) oder L) oder auf die Grundierungsschicht gemäß Schritt M) oder N) oder auf die Polysiloxanschicht gemäß Schritt O) oder P),
R) gegebenenfalls Plasmabehandlung mit dem Plasmagenerator und/oder Corona-Behandlung der Metallschicht gemäß Schritt Q),
S) Behandeln der nach Schritt Q) oder R) erhaltenen Metallschicht mit mindestens einer siliziumorganischen Verbindung, insbesondere mittels Plasmapolymerisation, unter Ausbildung einer Polysiloxanschicht,
T) Plasmabehandlung mit dem Plasmagenerator und/oder Corona-Behandlung der Polysiloxanschicht gemäß Schritt S) und
U) Auftragen einer, insbesondere transparenten, Deckschicht auf die behandelte Polysiloxanschicht gemäß Schritt T).

Die der Erfindung zu Grunde liegende Aufgabe wird insbesondere auch durch ein solches Verfahren gelöst, umfassend die Schritte
A) Zurverfügungstellung eines Metallsubstrats mit mindestens einer zumindest bereichsweise beschichtbaren Oberfläche,
B) Zurverfügungstellung einer Applikationsanlage für die Aufbringung einer Metallschicht, insbesondere Vakuumaufdampfanlage,
C) Zurverfügungstellung mindestens eines Plasmagenerators und/oder mindestens einer Corona-Anlage, insbesondere in der Applikationsanlage für die Aufbringung einer Metallschicht, wie Vakuumaufdampfanlage oder der Sputter-Anlage, oder als Bestandteil hiervon,
D) Reinigung des Metallsubstrats oder der beschichtbaren Oberfläche des Metallsubstrats,
M) Aufbringen mindestens einer Grundierungsschicht auf das Metallsubstrat oder die beschichtbare Oberfläche des Metallsubstrats gemäß Schritt D),
Q) Aufbringen mindestens einer Metallschicht, enthaltend oder bestehend aus einem ersten Metall ausgewählt aus der Gruppe bestehend aus Aluminium, Silber, Gold, Blei, Vanadium, Mangan, Magnesium, Eisen, Kobalt, Molybdän, Wolfram, Nickel, Kupfer, Chrom, Palladium, Platin, Titan, Zirkonium und Zink, insbesondere Aluminium, oder enthaltend oder bestehend aus einer ersten Metalllegierung ausgewählt aus der Gruppe bestehend aus Messing, Bronze, Stahl, insbesondere Edelstahl, Aluminium-, Magnesium- und Titanlegierungen, mit der Applikationsanlage, insbesondere mittels Aufdampf- und/oder Sputter-Technik, auf die Grundierungsschicht gemäß Schritt M),
S) Behandeln der nach Schritt Q) erhaltenen Metallschicht mit mindestens einer siliziumorganischen Verbindung, insbesondere mittels Plasmapolymerisation, unter Ausbildung einer Polysiloxanschicht,
T) Plasmabehandlung mit dem Plasmagenerator und/oder Corona-Behandlung der Polysiloxanschicht gemäß Schritt S) und
U) Auftragen einer, insbesondere transparenten, Deckschicht auf die Polysiloxanschicht gemäß Schritt T).

Es hat sich für einige Anwendungen gezeigt, dass es auch bei der Herstellung von beschichteten Metallsubstraten von Vorteil ist, wenn beidseitig der Metallschicht eine, insbesondere plasmapolymerisierte, Polysiloxanschicht vorliegt, d.h. Verfahrensschritt O) mit zwischengeschaltet wird, vorzugsweise mit anschließender Plasmabehandlung und/oder Corona-Behandlung, insbesondere Plasmabehandlung. Somit kann zum Beispiel auch die vorangehend geschilderte Verfahrensvariante mit Schritt O) ausgestattet sein.

Ein besonders ausgeprägter Korrosionsschutz wird bei den nach dem erfindungsgemäßen Verfahren erhältlichen Metallsubstrat auch dadurch erhalten, dass man auf das gemäß Schritt D) gereinigte Metallsubstrat oder die gereinigte beschichtbare Oberfläche des Metallsubstrats mindestens eine Metallschicht, enthaltend oder bestehend aus einem zweiten Metall ausgewählt aus der Gruppe bestehend aus Titan, Hafnium und Zirkonium, insbesondere Zirkonium, oder aus einer zweiten Metalllegierung ausgewählt aus der Gruppe bestehend aus Titan-, Hafnium- und Zirkoniumlegierungen, mit der Applikationsanlage, insbesondere mittels Aufdampf- und/oder Sputter-Technik, aufbringt (Schritt E)). Besonders vorteilhaft ist hierbei, wenn diese Metallschicht nachfolgend einem Plasmabehandlungsschritt unterzogen wird (Schritt F)).

Ferner kann vorgesehen sein, für die Herstellung beschichteter Metallsubstrate neben den Verfahrensschritten A) bis C) auf die Verfahrensschritte D), G), H), M), Q), S), T) und U) bzw. D), G), H), M), O), Q), S), T) und U) als zwingende Verfahrensschritte zurückzugreifen.

Darüber hinaus liefert das erfindungsgemäße Verfahren unter Einhaltung der Abfolge der zwingenden Verfahrensschritte D), E), G), H), M), Q), S), T) und U) oder unter Einhaltung der Abfolge der zwingenden Verfahrensschritte D), E), G), H), M), O), Q), S), T) und U) oder unter Einhaltung der Abfolge der zwingenden Verfahrensschritte D), M), N), Q), S), T) und U) oder unter Einhaltung der Abfolge der zwingenden Verfahrensschritte D), M), N), O), Q), S), T) und U) oder unter Einhaltung der Abfolge der zwingenden Verfahrensschritte D), G), H), Q), S), T) und U) oder unter Einhaltung der Abfolge der zwingenden Verfahrensschritte D), G), H), O), Q), S), T) und U) sehr zufriedenstellende Resultate hinsichtlich Haftung, Glanz und Korrosionsbeständigkeit, und zwar insbesondere auch dann, wenn die Verfahrensschritte in der genannten Abfolge unmittelbar aufeinanderfolgen.

Auch ist die folgende Verfahrensfolge sehr zweckmäßig, bei der neben den Verfahrensschritten A) bis C) Gebrauch gemacht wird von der Abfolge D), I), K), L), Q), S), T) und U) oder von der Abfolge D), F), Q), S), T) und U) oder von der Abfolge D), G), H), Q), S), T) und U).

In einer besonders zweckmäßigen Ausgestaltung wird die Schicht, auf die die Metallschicht gemäß Schritt Q) aufgebracht wird, vor dem Schritt Q) einer Plasmabehandlung mit dem Plasmagenerator und/oder einer Corona-Behandlung unterzogen (beispielsweise Schritte P), N), L), J), H), F) oder D)). Dies trifft insbesondere auch auf die Polysiloxanschicht zu.

Auch hat es sich in einer bevorzugten Ausführungsform als günstig insbesondere in Bezug auf gute Haftung und Korrosionsschutz erwiesen, wenn das metallische Substrat, insbesondere das gereinigte metallische Substrat, einer Plasmabehandlung und/oder Corona-Behandlung, insbesondere Plasmabehandlung, unterzogen wird (Schritt F)).

Vielfach hat es sich daher als vorteilhaft erwiesen, dass, wenn eine Polysiloxanschicht aufgetragen wird, diese Schicht anschließend einer Plasmabehandlung und/oder einer Corona-Behandlung, insbesondere einer Plasmabehandlung, unterzogen wird. Das gleiche trifft auf die Anbringung einer Grundierungsschicht zu. Auch hier hat es sich als vorteilhaft erwiesen, die erhaltene Grundierungsschicht zunächst einer Plasmabehandlung und/oder einer Corona-Behandlung zu unterziehen, insbesondere einer Plasmabehandlung.

Demgemäß hat es sich auch bei der Herstellung beschichteter Metallsubstrate nach dem erfindungsgemäßen Verfahren als vorteilhaft erwiesen, die vorangehend genannten Verfahrensschritte im Wesentlichen unmittelbar aufeinanderfolgen zu lassen. Dies bedeutet insbesondere, dass nach den Plasmabehandlungsschritten eine längere Lagerung vermieden werden sollte. Vielmehr ist es von Vorteil, wenn der nachfolgende Verfahrensschritt direkt folgt. Auch hat sich gezeigt, dass neben den vorangehend genannten Verfahrensschritten es nicht erforderlich ist, weitere Verfahrensschritte zwischen zu schalten.

Für die Metallsubstrate kann auf Metalle und Metalllegierungen zurückgegriffen werden, wobei besonders geeignete Metallsubstrate ausgewählt werden können aus der Gruppe bestehend aus Aluminium, Aluminiumlegierungen, Eisen, Eisenlegierungen, insbesondere Stahl oder Edelstahl, Kupfer, Kupferlegierungen, Titan, Titanlegierungen, Zink, Zinklegierungen, Nickel, Nicklegierungen, Molybdän, Molybdänlegierungen, Magnesium, Magnesiumlegierungen, Blei, Bleilegierungen, Wolfram, Wolframlegierungen, Mangan, Manganlegierungen, Messing, Bronze, Nickeldruckguss, Zinkdruckguss und Aluminiumdruckguss oder deren beliebige Mischungen.

Geeignete Verfahren zur Reinigung von Metallsubstraten sind dem Fachmann bekannt. Derartige Reinigungsverfahren (Schritt D)) umfassen das Entfetten, Dekapieren, Phosphatieren, insbesondere Eisen- und/oder Zinkphosphatieren, Polieren, Schleifen, insbesondere Gleitschleifen, und/oder Behandeln mit Trockeneis. Diese Verfahren können sowohl einzeln als auch in beliebiger Kombination eingesetzt werden. Für viele Anwendungen hatte sich als ausreichend erwiesen, die Metallsubstrate durch Behandlung mit Trockeneis zu reinigen. Bei der Reinigung mit Trockeneis werden im Allgemeinen Trockeneispartikeln in Form von Pellets oder in Form von Kristallen, die von einem entsprechenden Trockeneisblock abgeschabt worden sind, mit Hilfe von Druckluft beschleunigt und auf die zu reinigende Metalloberfläche geleitet. Der Reinigungseffekt soll hierbei auf thermische, kinetische und Phasenumwandlungseffekte zurückzuführen sein. Vorrichtungen und Verfahren zur Reinigung von Metalloberflächen mit Trockeneis sind zum Beispiel der DE 195 44 906 A1 und EP 2 886 250 zu entnehmen.

Die Oberfläche von Metallsubstrate kann beispielsweise mit alkalischen oder sauren Reagenzien entfettet werden. Kommerzielle Entfettungsschritte sind auch unter den Begriffen Abkoch- bzw. Beizentfetten bekannt. Alternativ kann eine Metalloberfläche in einem elektrolytischen Entfettungsbad anodisch entfettet werden.

Für manche Ausführungsvarianten ist es vorteilhaft, die, insbesondere entfettete, Metallsubstratoberfläche mindestens einem Dekapierschritt zu unterziehen. Für die Dekapierung der Metallsubstratoberfläche setzt man z.B. ein saures Spülbad ein. Eine geeignete Dekapierlösung stellt demgemäß z.B. verdünnte Salzsäure (1:10 vol/vol) dar. Im Ergebnis erhält man mittels Dekapierung in der Regel eine im Wesentlichen oxidfreie Metalloberfläche. Ebenso wie der Entfettungsschritt wird auch der Dekapierschritt im Allgemeinen durch einen Spülschritt abgeschlossen. Wird die Metallsubstratoberfläche poliert und/oder geschliffen bzw. gleitgeschliffen, kann häufig der Entfettungs- und/oder Dekapierschritt entfallen. Üblicherweise wird bei dieser Art der Oberflächenbearbeitung hinreichend Material von dieser Oberfläche abgetragen, womit dann auch auf der Oberfläche aufliegende bzw. anhaftende Verunreinigungen oder anderweitige Bestandteile mit entfernt werden. Wird die Oberfläche poliert bzw. geschliffen, kann überdies häufig auch auf die Auftragung einer ersten und gegebenenfalls zweiten Grundierschicht verzichtet werden. Mit dem Polieren bzw. Schleifen wird zumeist bereits eine derart ebene bzw. glatte Oberfläche erhalten, dass eine Einglättung durch Aufbringen einer Grundierschicht nicht mehr erforderlich ist. Allerdings kann es, wenn das Metallsubstrat zahlreiche Winkel und Ecken aufweist, die sich nicht ohne weiteres hinreichend polieren bzw. schleifen lassen, empfehlenswert sein, einen ersten und möglicherweise auch einen zweiten Grundierschritt nachzuschalten.

Anschließend an oder anstelle des Entfettungsschritts kann die metallische Substratoberfläche phosphatiert und/oder zu passiviert werden. Dies ist insbesondere bei Substraten aus oder enthaltend Aluminium bevorzugt.

In einer weiteren Ausgestaltung des erfindungsgemäßen Verfahrens zur Herstellung beschichteter Metallsubstrate gelangt man dadurch zu ganz besonders korrosionsbeständigen Substraten, dass in dem Schritt der Aufbringung der Metallschicht ein erstes Metall, insbesondere Aluminium, oder eine erste Metalllegierung, insbesondere eine Aluminiumlegierung, in der Applikationsanlage für die Aufbringung einer Metallschicht, insbesondere der Vakuumaufdampfanlage oder der Sputter-Anlage, zeitlich überlappend mit einem zweiten Metall, das von dem ersten Metall verschieden ist, insbesondere ausgewählt aus der Gruppe bestehend aus Titan, Zirkonium und Hafnium, insbesondere Zirkonium, oder mit einer zweiten Metalllegierung, insbesondere einer Zirkoniumlegierung, die von der ersten Metalllegierung verschieden ist, co-verdampft wird. Dieses gelingt beispielsweise in der Weise, dass Metallpellets oder -stäbe des ersten Metalls oder der ersten Metalllegierung in ein entsprechendes erstes Aufnahmebehältnis, insbesondere erstes Schiffchen oder eine erste Wendel, gegeben werden und das Metallpellets oder -stäbe des zweiten Metalls oder der zweiten Metalllegierung in ein entsprechendes zweites Aufnahmebehältnis, zweites Schiffchen oder eine zweite Wendel, gegeben werden und dass das erste und das zweite Aufnahmebehältnis in der Weise aufgeheizt werden, dass die Schmelzpunkte von erstem und zweiten Metall bzw. erster und zweiter Metalllegierung bzw. von erstem Metall und zweiter Metalllegierung bzw. von erster Metalllegierung und zweitem Metall im Wesentlichen gleichzeitig oder innerhalb eines überlappenden Zeitraums erreicht und/oder aufrechterhalten werden.

Geeignete wässrige Konversionssysteme, mit deren Hilfe Konversionsschichten erhalten werden, sind dem Fachmann geläufig. Exemplarisch sei auf die Offenbarungen der US 2,825,697 und US 2,928,763 verwiesen.

Zur Aufbringung der Grundierungsschicht stehen dem Fachmann allseits bekannte Verfahren zur Verfügung. Exemplarisch seien das Nasslackverfahren, das Pulverbeschichtungsverfahren oder die Auftragung mittels UV-härtender Beschichtungssysteme genannt. Demgemäß kann die Grundierungsschicht in einer bevorzugten Ausgestaltung auf, insbesondere UV-härtende, pulverförmige Polyesterharzverbindungen oder auf Epoxid/Polyester-Pulver zurückgehen. Selbstverständlich ist es auch möglich, vor der Aufbringung einer Grundierungsschicht, wie vorangehend beschrieben, eine mechanische Glättung der Metallsubstratoberfläche, beispielsweise mittels Schleifens und/oder Polierens bzw. Gleitschleifens, durchzuführen.

Geeignete siliziumorganische Verbindungen sind dem Fachmann bekannt. In einer zweckmäßigen Ausgestaltung wird hierfür zurückgegriffen auf mindestens ein aminohaltiges Silan, insbesondere Aminopropyltriethoxysilan, Hexamethyldisiloxan, Tetramethyldisiloxan oder deren beliebige Mischungen. Besonders bevorzugt kommen Hexamethyldisiloxan und Tetramethyldisiloxan zum Einsatz, wobei Hexamethyldisiloxan regelmäßig besonders geeignet ist.

Geeignete siliziumorganische Verbindungen umfassen ebenfalls, als Monomer- oder als Comonomer-Bausteine, Verbindungen der folgenden Formel (I):

X-R₁-Si(R₂)₃₋ₘ(R₃)ₘ (I),

wobei die Substituenten und Indizes die folgende Bedeutung haben:
- m: 0, 1, 2 oder 3, insbesondere 2 oder 3,
- R1: C1- bis C10-Kohlenwasserstoffrest insbesondere eine C1- bis C10-Kohlenwasserstoffkette, die durch Sauerstoff oder Stickstoff unterbrochen sein kann, insbesondere Methyl, Ethyl oder i- oder n-Propyl, vorzugsweise i- oder n-Propyl,
- R2: gleiche oder verschiedene hydrolysierbare Gruppen, insbesondere Alkoxygruppen wie Methoxy-, Ethoxy-, n-Propoxy, i-Propoxy, n-Butoxy, i-Butoxy oder t-Butoxy, insbesondere Methoxy oder Ethoxy,
- R3: gleiche oder verschiedene C1- bis C5-Alkylgruppen, insbesondere Methyl, Ethyl oder i- oder n-Propyl, vorzugsweise i- oder n-Propyl,
- X: funktionelle polymerisierbare Gruppe, insbesondere ein in ω-Stellung ungesättigter organischer Rest wie eine in ω-Stellung ungesättigte Alkenylgruppe mit 1 bis 10, vorzugsweise 2 bis 4 C-Atomen oder ein in ω-Stellung ungesättigter Carbonsäureesterrest von Carbonsäuren mit bis zu 4 Kohlenstoffatomen und Alkoholen mit bis zu 6 Kohlenstoffatomen.

Besonders geeignete Reste X umfassen z.B. Vinyl, Alkylvinyl, insbesondere Methyl-, Ethyl- oder Propylvinyl, (Meth)acryloxyalkyl, insbesondere (Meth)acryloxymethyl, (Meth)acryloxyethylen oder (Meth)acryloxypropyl, insbesondere (Meth)acryloxypropyl.

In einer Weiterentwicklung der erfindungsgemäßen Verfahren ist vorgesehen, dass eine erste siliziumorganische Verbindung über eine Zuführleitung aus einem außerhalb der Applikationsanlage für die Aufbringung einer Metallschicht, insbesondere außerhalb der Vakuumkammer der Vakuumaufdampfanlage, befindlichen ersten Behältnis dieser Applikationsanlage, insbesondere Vakuumkammer, zugeführt wird und dass eine zweite siliziumorganische Verbindung , die von der ersten siliziumorganische Verbindung verschieden ist, über eine Zuführleitung aus einem außerhalb der Applikationsanlage für die Aufbringung einer Metallschicht, insbesondere außerhalb der Vakuumkammer der Vakuumaufdampfanlage, befindlichen zweiten Behältnis dieser Applikationsanlage, insbesondere Vakuumkammer, zugeführt wird. Alternativ kann in dem ersten und dem zweiten Behältnis auch die gleiche siliziumorganische Verbindung vorliegen. Insbesondere ist es möglich, dass auch bei Verwerdung gleicher siliziumorganischer Verbindungen eine dieser siliziumorganische Verbindungen mit einer weiteren, anderen siliziumorganische Verbindung und/oder mit einem Farbmittel, insbesondere Farbstoff, vermengt vorliegen kann. Demgemäß zeichnen sich die erfindungsgemäßen Verfahren auch dadurch aus, dass man gemeinsam mit der mindestens einen siliziumorganischen Verbindung, insbesondere für die Plasmapolymerisation, mindestens ein Farbmittel, insbesondere einen Farbstoff, in die Applikationsanlage für die Aufbringung einer Metallschicht, vorzugsweise in Form eines Gemisches, einbringt. Letztgenannte Verfahrensvariante umfassend den Einsatz eines Farbmittels gelingt selbstverständlich ebenfalls bei Anwendung von nur einem Behälter.

Demgemäß wird mit der vorliegenden Erfindung ebenfalls abgestellt auf eine Applikationsanlage für die Aufbringung einer Metallschicht umfassend mindestens ein erstes, insbesondere außerhalb der Applikationsanlage für die Aufbringung einer Metallschicht, insbesondere außerhalb der Vakuumkammer der Vakuumaufdampfanlage, vorliegendes Behältnis zur Aufnahme einer ersten siliziumorganischen Verbindung mit einer Zuführleitung zu der Applikationsanlage, insbesondere zur Vakuumkammer, und mindestens ein zweites, insbesondere außerhalb der Applikationsanlage für die Aufbringung einer Metallschicht, insbesondere außerhalb der Vakuumkammer der Vakuumaufdampfanlage, vorliegendes Behältnis zur Aufnahme einer zweiten siliziumorganischen Verbindung mit einer Zuführleitung zu der Applikationsanlage, insbesondere zur Vakuumkammer.

Eine besonders gute Haftung ohne Einschränkungen bei der Korrosionsbeständigkeit erhält man insbesondere auch dadurch, dass der Schritt der Behandlung mit mindestens einer siliziumorganischen Verbindung wie Hexamethyldisiloxan, insbesondere mittels Plasmapolymerisation, unter Ausbildung einer Polysiloxanschicht in Gegenwart mindestens eines reaktiven Gases wie Sauerstoff, Stickstoff, Kohlendioxid, Wasserstoff, Kohlenmonoxid, Wasserstoffperoxidgas, Wasserdampf, Ozon und/oder Luft, insbesondere in Gegenwart von Sauerstoff oder Luft, durchgeführt wird. Über die Einbindung von reaktiven Gasen, insbesondere Luft oder Sauerstoff, in den, insbesondere plasmagenerierten, Polymerisationsprozess erhält man härtere Polysiloxanschichten als bei der herkömmlichen Herstellung solcher Polysiloxanschichten ohne Mitverwendung der geschilderten reaktiven Gas. Diese härteren Polysiloxanschichten zeichnen sich auch durch eine größere Diffusionsgeschlossenheit aus. Hierbei kann in einer besonders zweckmäßigen Ausführungsform vorgesehen sein, dass die mindestens eine siliziumorganische Verbindung, insbesondere Hexamethyldisiloxan, und das mindestens eine reaktive Gas, insbesondere Sauerstoff oder Luft, als Mischung für den Behandlungsschritt eingesetzt werden. Die vorangehend geschilderte Ausführungsform der Mitverwendung reaktive Gase bei der, insbesondere plasmagenerierten, Herstellung der Polysiloxanschicht kommt vorzugsweise bei mindestens einem Schritt der Behandlung mit mindestens einer siliziumorganischen Verbindung, insbesondere mittels Plasmapolymerisation, unter Ausbildung einer Polysiloxanschicht oder aber auch bei jedem Schritt zur Herstellung einer Polysiloxanschicht zum Einsatz. Besonders bevorzugt wird diese Verfahrensvariante bei der Herstellung beschichteter nicht-metallischer Substrate, insbesondere von Kunststoffsubstraten, in Verfahrensschritt m) und bei der Herstellung beschichtete metallischer Substrate in Verfahrensschritt S) eingesetzt. In den den genannten Verfahrensschritten folgenden Verfahrensschritten n) bzw. T) wird die Plasmabehandlung bevorzugt mit Hilfe eines Plasmagases gebildet aus einem Inertgas, insbesondere Argon, und Sauerstoff oder Luft oder Stickstoff, insbesondere Sauerstoff, oder mit Hilfe eines Plasmagases gebildet aus Sauerstoff, Luft oder Stickstoff durchgeführt. Auch diese Vorgehensweise trägt nochmals zu einer verbesserten Haftung des Gesamtsystems, umfassend die Deckschicht bei.

Für den Schritt der Plasmabehandlung mit dem Plasmagenerator stehen grundsätzlich mehrere Verfahrensvarianten zur Auswahl. Gemäß einer ersten Variante kann das Plasma unter Einsatz mindestens eines Inertgases, insbesondere Argon, gebildet werden. Alternativ kann für die Generierung eines geeigneten Plasmas auch auf Mischungen aus mindestens einem Inertgas, insbesondere Argon, und einem reaktiven Gas wie Sauerstoff, Stickstoff, Kohlendioxid, Wasserstoff, Kohlenmonoxid, Wasserstoffperoxidgas, Wasserdampf, Ozon und/oder Luft zurückgegriffen werden. Bevorzugt kommen hierbei Sauerstoff und Stickstoff, insbesondere Sauerstoff, zum Einsatz. Schließlich ist es auch möglich, unter Verzicht von Inertgasen ausschließlich reaktive Gase wie Sauerstoff, Stickstoff, Wasserstoff, Kohlendioxid, Kohlenmonoxid, Wasserstoffperoxidgas, Wasserdampf, Ozon und/oder Luft für die Erzeugung des Plasmas einzusetzen. Hierbei wird bevorzugt auf Sauerstoff zurückgegriffen. Mit Hilfe einer Plasmabehandlung mit dem Plasmagenerator wird die zu beschichtende Oberfläche des Substrats aktiviert. Bei einem Plasmaverfahren wirkt regelmäßig ein energiereiches Plasma auf die Oberfläche des Formteils ein, so dass auf dieser Oberfläche aktive Zentren gebildet werden. Hierbei kann es sich beispielsweise um Hydroxygruppen und/oder um Carbonyl-Gruppen handeln. In gleicher Weise kann eine Aktivierung der Oberfläche der zu beschichtenden Oberfläche des Substrats im Wege der Beflammung erfolgen. Hierbei kann in einer bevorzugten Ausgestaltung einer Flamme, beispielsweise einer Propangasflamme, welche in einer Luftatmosphäre brennt, ein flüchtiges Silan oder eine Verbindung, die Titan und Aluminium enthält, zugesetzt werden. Durch die Beflammung kann die Oberflächen des Substrats, insbesondere eines Kunststoffsubstrats, in ähnlicher Weise verändert werden wie beim Plasmaverfahren, zum Beispiel unter Ausbildung von Hydroxygruppen.

Die erfindungsgemäßen Verfahren bieten den großen Vorteil, dass nahezu sämtliche Verfahrensschritte in der Applikationsanlage für die Aufbringung einer Metallschicht durchgeführt werden können. Dies betrifft neben der Aufbringung der Metallschichten auch die Aktivierung von Oberflächen mittels der Plasmabehandlung mit dem Plasmagenerator ebenso wie die Aufbringung der Polysiloxanschicht, insbesondere mittels Plasmapolymerisation. Einzig die Reinigungsschritte, die Aufbringung einer Grundierungsschicht, die Aufbringung einer Konversionsschicht und die Aufbringung der Deckschicht werden regelmäßig außerhalb der genannten Applikationsanlage aufgebracht. Demgemäß kann vorgesehen sein, das die, insbesondere jede, Plasmabehandlung mit dem Plasmagenerator und/oder die, insbesondere jede, Aufbringung der Metallschicht und/oder die, insbesondere jede, Aufbringung der Polysiloxanschicht in der Applikationsanlage für die Aufbringung einer Metallschicht, insbesondere in der Vakuumaufdampfanlage oder in der Sputter-Anlage, vorgenommen wird und/oder dass die Aufbringung der Grundierungsschicht und/oder die Aufbringung der Konversionsschicht und/oder die Aufbringung der Deckschicht außerhalb der Applikationsanlage für die Aufbringung einer Metallschicht, insbesondere der Vakuumaufdampfanlage oder der Sputter-Anlage, vorgenommen wird.

Für die Deckschicht kann z.B. auch auf wasserverdünnbare Beschichtungszusammensetzungen zurückgegriffen werden. Die Deckschicht kann gebildet werden aus Polyacrylatharzen, Polyesterharzen, Aminoplastharzen oder Polyurethanverbindungen. Bevorzugt werden bei den erfindungsgemäßen Verfahren solche Deckschichten aufgetragen, die auf ein UVhärtendes Beschichtungsmaterial zurückgehen. Demgemäß stellt eine bevorzugte Deckschicht eine UV-gehärtete Deckschicht dar. Die Deckschicht kann z.B. über einen Klarlack oder ein transparentes Pulver erhalten werden. Vorzugsweise wird die Deckschicht über ein Nasslackverfahren bzw. ein Pulverbeschichtungsverfahren aufgetragen. Bei der Deckschicht kann es sich demgemäß zum Beispiel um ein-, zwei- oder mehrkomponentige Lacke handeln, wobei Klarlacke bevorzugt sind. Bei diesen Klarlacken kann es sich z.B. um chemisch vernetzende zweikomponentige, um einkomponentige wärmehärtende oder um UV-härtende Lacke handeln. Des Weiteren kann für die Deckschicht auf 1K- oder 2K-Einbrennlack zurückgegriffen werden.

Die Deckschicht verfügt in der Regel über eine Dicke im Bereich von 10 bis 50 µm, vorzugsweise im Bereich von 20 bis 30 µm. Erfindungswesentlich für die erfindungsgemäßen Verfahren ist, dass das die Deckschicht bildende Material auf eine zuvor mittels Plasmabehandlung und/oder Corona-Behandlung aktivierte Polysiloxanschicht, welche wiederum bevorzugt im Wege einer Plasmapolymerisation erhalten wurde, aufgetragen wird, und zwar vorzugsweise im Wesentlichen ohne zeitliche Verzögerung.

Die Plasmabehandlung mit dem Plasmagenerator wird mitunter auch mit dem Begriff Glimmen beschrieben.

Für die Auftragung der Metallschichten kann zum Beispiel zurückgegriffen werden auf die Techniken der Physical Vapour Deposition (PVD), Chemical Vapour Deposition (CVD), des Aufdampfens mittels eines Elektronenstahl-Verdampfers, des Aufdampfens mittels eines Widerstandsverdampfers, der Induktionsverdampfung, der ARC-Verdampfung oder der Kathoden- bzw. Anodenzerstäubung (Sputter-Beschichtung). Demgemäß kommen als Applikationsanlagen für die Aufbringung einer Metallschicht zum Beispiel vorzugsweise Vakuumaufdampfanlagen oder Sputter-Anlagen in Frage. Geeignete Vakuumaufdampfanlagen umfassen zweckmäßigerweise PVD-Anlagen (Physical Vapour Deposition), CVD-Anlagen (Chemical Vapour Deposition), Elektronenstahl-Verdampfer, Widerstandsverdampfer, Induktionsverdampfer und ARC-Verdampfer. Geeignete Sputter-Anlagen umfassen zum Beispiel Kathodenzerstäuber und Anodenzerstäuber. Wie dem Fachmann bekannt ist, besteht eine Metallschicht vorwiegend aus Metall. Dies schließt Zusätze, wie sie beispielsweise bei rostfreiem Stahl in Form von Kohlenstoff zum Einsatz kommen, nicht gänzlich aus. Vorzugsweise ist der Metallanteil der vorliegenden Metallschicht größer 90 Gew%, insbesondere 95 Gew% und ganz besonders bevorzugt ≥ 98 Gew%.

Vorzugsweise ist die Metallschicht eine aufgedampfte oder aufgesputterte Metallschicht, insbesondere ein PVD-Metallschicht. Beim PVD-Verfahren kommen im Allgemeinen widerstandsbeheizte Metallwendel- oder Metallschiffchenverdampfer zum Einsatz, wobei Wolframwendeln der verschiedensten Form bevorzugt sind. Beim PVD-Verfahren wird im Allgemeinen ein Verdampfer mit Wendeln bestückt, die auf voneinander isolierten Verdampferschienen geklemmt werden können. In jede Wendel wird vorzugsweise eine genau bestimmte Menge an aufzudampfendem Metall gegeben. Nach dem Schließen und Evakuieren der PVD-Anlage kann die Verdampfung durch Einschalten der Stromversorgung, wodurch man die Verdampferschienen die Wendel zum Glühen bringt, gestartet werden. Das feste Metall beginnt zu schmelzen und benetzt die meist verdrillten Wendeln vollständig. Durch weitere Energiezufuhr wird das flüssige Metall in die Gasphase überführt, so dass es sich auf dem zu beschichtenden Substrat abscheiden kann. Über die Menge an in die Gasphase überführtem Metall und/oder die Dauer der Beschichtungsphase kann die Dicke der Metallschicht, und damit auch das Erscheinungsbild derselben gezielt eingestellt werden.

Ein weiteres bevorzugtes Verfahren zur Abscheidung der Metallschicht auf dem Substrat ist die Kathodenzerstäubung (Sputter-Verfahren). Dabei wird in einem evakuierten Behälter eine Kathode angeordnet, die mit dem negativen Pol einer Stromversorgung verbunden ist. Das Beschichtungsmaterial, das zerstäubt wird, wird unmittelbar vor der Kathode montiert und die zu beschichtenden Substrate werden gegenüber dem zu zerstäubenden Beschichtungsmaterial angeordnet. Ferner kann Argon als Prozessgas durch den Behälter geleitet werden, der schließlich noch eine Anode aufweist, die mit dem positiven Pol einer Stromversorgung verbunden ist. Nachdem der Behälter vorevakuiert worden ist, werden Kathode und Anode mit der Stromversorgung verbunden. Durch den gezielten und gesteuerten Einlass von Argon wird die mittlere freie Weglänge der Ladungsträger deutlich gesenkt. Im elektrischen Feld zwischen Kathode und Anode werden Argonatome ionisiert. Die positiv geladenen Teilchen werden mit hoher Energie zur negativ geladenen Kathode beschleunigt. Beim Auftreffen und durch Teilchenstöße im Beschichtungsmaterial wird dieses in die Dampfphase überführt, mit hoher Energie in den freien Raum beschleunigt und kondensiert dann auf den zu beschichtenden Substraten. Mit dem Sputter-Verfahren lassen sich unterschiedliche Metallschichtdicken gezielt einstellen.

Die mit den genannten Verfahren und Anlagen erhältlichen Metallschichten verfügen vorzugsweise über eine durchschnittliche, insbesondere absolute, Dicke im Bereich von 1 nm bis 150 nm insbesondere im Bereich von 5 nm bis 120 nm. In einer sehr zweckmäßigen Ausgestaltung des nach den erfindungsgemäßen Verfahren erhaltenen beschichteten Substrats wird die Metallschicht zum Beispiel mit einer Dicke im Bereich von 60 nm bis 120 nm, vorzugsweise mit einer Dicke im Bereich von 75 nm bis 110 nm eingestellt. Bei diesen Dicken liegen die Metallschicht, insbesondere der Aluminiumschicht, deckend, d.h. im Wesentlichen nicht transparent oder transluzent auf der Oberflächen auf. Hierdurch können hochglänzende Schichten erhalten werden.

Eine Einfärbung der auf den nicht-metallischen und metallischen Substraten vorliegenden Beschichtung kann mit den erfindungsgemäßen Verfahren auch dadurch bewerkstelligt werden, dass für das Auftragen der Deckschicht ein Beschichtungsmaterial enthaltend mindestens ein Farbmittel, z.B. mindestens ein Pigment und/oder mindestens einen Farbstoff, eingesetzt wird. Auch lassen sich dem Fachmann bekannte Lasuren verwenden, um die Deckschicht einzufärben, beispielsweise um Messing-, Titan- und Goldtöne oder individuelle Farbtöne wie rot, blau, gelb, grün, etc. oder Eloxalfarbtöne zu erhalten. Zum Beispiel können in die Deckschicht auch Effektpigmente wie Perlglanzpigmente, LCP-Pigmente (liquid crystal polymer) oder OV-Pigmente (optical variable) eingearbeitet werden.

Eine geeignete Applikationsanlage für die Aufbringung einer Metallschicht umfasst oder stellt dar eine Vakuumaufdampfanlage mit einer Vakuumkammer, und mindestens eine, insbesondere eine Vielzahl an ersten beheizbaren Aufnahmeeinheiten, insbesondere Schalen, Schiffchen oder Wendeln, jeweils in Wirkverbindung mit einer ersten Heizeinrichtung oder eine erste Heizeinrichtung umfassend oder darstellend, jeweils ausgelegt und geeignet für die Aufnahme eines ersten Metalls oder einer ersten Metalllegierung mit einem ersten Schmelzpunkt oder Schmelzbereich, und mindestens eine, insbesondere eine Vielzahl an zweiten beheizbaren Aufnahmeeinheiten, insbesondere Schalen, Schiffchen oder Wendeln, jeweils in Wirkverbindung mit einer zweiten Heizeinrichtung oder eine zweite Heizeinrichtung umfassend oder darstellend, jeweils ausgelegt und geeignet für die Aufnahme eines zweiten Metalls oder zweiten Metalllegierung mit einem zweiten Schmelzpunkt oder Schmelzbereich, wobei der erste Schmelzpunkt oder der erste Schmelzbereich von dem zweiten Schmelzpunkt bzw. zweiten Schmelzbereich verschieden sind, und ferner eine Steuereinrichtung für die Einstellung von erster und zweiter Temperatur in der Weise, dass das erste und das zweite Metall oder die erste und zweite Metalllegierung im Wesentlichen zeitgleich oder zeitlich überlappend verdampfen (co-verdampfen).

Dabei kann in einer Ausführungsvariante vorgesehen sein, dass die Applikationsanlage für die Aufbringung einer Metallschicht mindestens ein erstes, insbesondere außerhalb der Vakuumkammer der Vakuumaufdampfanlage vorliegendes Behältnis zur Aufnahme einer ersten siliziumorganischen Verbindung mit einer Zuführleitung zur Vakuumkammer und mindestens ein zweites, insbesondere außerhalb der Vakuumkammer der Vakuumaufdampfanlage vorliegendes Behältnis zur Aufnahme einer zweiten siliziumorganischen Verbindung mit einer zu für Leitung zur Vakuumkammer umfasst.

Als besonders zweckdienlich hat es sich erwiesen, die Applikationsanlage für die Aufbringung einer Metallschicht ebenfalls auszustatten mit
mindestens einem, insbesondere in der Vakuumkammer vorliegenden, Gestell mit einer Längsorientierung und mit mindestens einem Träger, insbesondere in Form einer Welle, der im Wesentlichen entlang der Längsorientierung des Gestells ausgerichtet ist, ausgelegt und eingerichtet zur Aufnahme mindestens eines, insbesondere einer Vielzahl an nicht-metallischen und/oder metallischen Substraten, wobei das Gestell und/oder der mindestens eine Träger um eine, insbesondere im Wesentlichen horizontal ausgerichtete, Achse rotiert wahr sind. Geeignete Gestelle, die mit der Applikationsanlage verwendet werden können, sind zum Beispiel der EP 2 412 445 und der DE 20 2007 016 072 zu entnehmen.

Die nach dem erfindungsgemäßen Verfahren erhältlichen nicht-metallischen und metallischen Substrate können zum Beispiel eingesetzt werden als Zubehörteil für den Automobilbau, Motorradbau, Fahrradbau oder Schiffbau, für Felgen, insbesondere Leichtmetallfelgen, Räder, insbesondere Leichtmetallräder oder als Bestandteil hiervon, für Sanitäreinrichtungsgegenstände, insbesondere als Armatur, oder als Bestandteil hiervon, für Karosserieinnen- oder Außenbauteile oder als Bestandteil hiervon, für Griffe oder Griffkomponenten, insbesondere Türgriffe oder als Bestandteil hiervon, für Profile oder Rahmen, insbesondere Fensterrahmen oder als Bestandteil hiervon, für Beschlagsysteme oder als Bestandteil hiervon, insbesondere Schilder und Türschilder, für Gehäuse oder als Verpackung oder als Bestandteil hiervon, für Innen- oder Außenbauteile von Schiffen oder als Bestandteil hiervon, für Schmuckgegenstände oder als Bestandteil hiervon, für Edelbauteile oder als Bestandteil hiervon, für Innen- oder Außenmöbel oder für Bestandteile hiervon, für Haushaltsgeräte, insbesondere Kaffeemaschinen, oder Bestandteile hiervon, für Innen- oder Außenbauteile von Flugzeugen oder als Bestandteil hiervon, für Innen- oder Außenbauteile von Gebäuden oder als Bestandteil hiervon, für Heizkörper oder Rohre oder als Bestandteil hiervon, für Bauteile von Aufzügen oder als Bestandteil hiervon, für Bauteile von Elektronikkomponenten oder -Geräten oder als Bestandteil hiervon, für Bauteile von Küchengeräten, beispielsweise Kaffeemaschinen, oder als Bauteil von Kommunikationskomponenten oder -Geräten, insbesondere Handys, oder als Bestandteil hiervon.

Der Erfindung liegt die überraschende Erkenntnis zugrunde, dass mit den nach den erfindungsgemäßen Verfahren erhältlichen Substraten eine hochwertige Glanzbeschichtung zur Verfügung gestellt wird, die dauerhaft ihren Glanz behält. Außerdem wurde überraschend gefunden, dass die nach dem erfindungsgemäßen Verfahren erhältlichen beschichteten nicht-metallischen und metallischen Substrate mit einer hervorragenden Korrosionsbeständigkeit ausgestattet sind. Die nach den erfindungsgemäßen Verfahren erhältlichen beschichteten Substrate zeichnen sich zudem durch eine ausgeprägte Haftung aus. Demgemäß zeigen diese beschichteten Substrate selbst dann überragende Korrosionsbeständigkeiten, wenn die Oberflächen mechanische Beschädigungen erfahren haben, beispielsweise mittels Steinschlag oder durch Anritzen. Ein weiterer Vorteil, der mit den erfindungsgemäßen Verfahren einhergeht, ist, dass nur noch sehr geringe Umrüstzeiten erforderlich sind, um neue Substratschargen zu beschichten. Darüber hinaus ermöglicht das erfindungsgemäße Verfahren, den Umfang der Gesamtanlage zur Herstellung beschichteter Substrate ausgehend von dem noch nicht gereinigten, zu beschichtenden Substrat erheblich zu verringern, so dass ein signifikant reduzierter Platzbedarf gegenüber herkömmlichen Anlagen besteht. Darüber hinaus gelingt es mit den erfindungsgemäßen Verfahren, die Bearbeitungszeit bis zur Fertigstellung des beschichteten verkaufsfertigen Substrats erheblich zu verringern. Hiermit gehen zwangsläufig verringerte Zykluszeiten einher.

Die in der vorstehenden Beschreibung und in den Ansprüchen offenbarten Merkmale der Erfindung können sowohl einzeln aus auch in jeder beliebigen Kombination für die Verwirklichung der Erfindung in ihren verschiedenen Ausführungsformen wesentlich sein.

## Patentansprüche

1. Verfahren zur Herstellung eines beschichteten nicht-metallischen Substrats umfassend
a) Zurverfügungstellung eines nicht-metallischen Substrats mit mindestens einer zumindest bereichsweise beschichtbaren Oberfläche,
b) Zurverfügungstellung einer Applikationsanlage für die Aufbringung einer Metallschicht,
c) Zurverfügungstellung mindestens eines Plasmagenerators und/oder mindestens einer Corona-Anlage"
d) gegebenenfalls Plasmabehandlung mit dem Plasmagenerator und/oder Corona-Behandlung des nicht-metallischen Substrats oder der beschichtbaren Oberfläche des nicht-metallischen Substrats,
e) gegebenenfalls Behandeln des nach Schritt a) oder d) erhaltenen nicht-metallischen Substrats oder der beschichtbaren Oberfläche des nicht-metallischen Substrats mit mindestens einer siliziumorganischen Verbindung unter Ausbildung einer Polysiloxanschicht,
f) gegebenenfalls Plasmabehandlung mit dem Plasmagenerator und/oder Corona-Behandlung der Polysiloxanschicht gemäß Schritt e),
g) gegebenenfalls Aufbringen mindestens einer Grundierungsschicht auf das nicht-metallische Substrat oder die beschichtbare Oberfläche des nicht-metallischen Substrats gemäß Schritt a) oder d) oder auf die Polysiloxanschicht gemäß Schritt e) oder f),
h) gegebenenfalls Plasmabehandlung mit dem Plasmagenerator und/oder Corona-Behandlung der Grundierungsschicht gemäß Schritt g),
i) gegebenenfalls Behandeln der nach Schritt g) oder h) erhaltenen Grundierungsschicht mit mindestens einer siliziumorganischen Verbindung unter Ausbildung einer Polysiloxanschicht,
j) gegebenenfalls Plasmabehandlung mit dem Plasmagenerator und/oder Corona-Behandlung der Polysiloxanschicht gemäß Schritt i),
k) Aufbringen mindestens einer Metallschicht, enthaltend oder bestehend aus einem ersten Metall ausgewählt aus der Gruppe bestehend aus Aluminium, Silber, Gold, Blei, Vanadium, Mangan, Magnesium, Eisen, Kobalt, Nickel, Kupfer, Chrom, Palladium, Molybdän, Wolfram, Platin, Titan, Zirkonium und Zink oder enthaltend oder bestehend aus einer ersten Metalllegierung ausgewählt aus der Gruppe bestehend aus Messing, Bronze, Stahl, Aluminium-, Magnesium- und Titanlegierungen, mit der Applikationsanlage auf das nicht-metallische Substrat oder auf die beschichtbare Oberfläche des nicht-metallischen Substrats gemäß Schritt a) oder d) oder auf die Polysiloxanschicht gemäß Schritt e) oder f) oder auf die Grundierungsschicht gemäß Schritt g) oder h) oder auf die Polysiloxanschicht gemäß Schritt i) oder j),
l) gegebenenfalls Plasmabehandlung mit dem Plasmagenerator und/oder Corona-Behandlung der Metallschicht gemäß Schritt k),
m) Behandeln der nach Schritt k) oder l) erhaltenen Metallschicht mit mindestens einer siliziumorganischen Verbindung unter Ausbildung einer Polysiloxanschicht,
n) Plasmabehandlung mit dem Plasmagenerator und/oder Corona-Behandlung der Polysiloxanschicht gemäß Schritt m) und
o) Auftragen einer Deckschicht auf die behandelte Polysiloxanschicht gemäß Schritt n).

2. Verfahren nach Anspruch 1, **dadurch gekennzeichnet, dass**
die Schritte g), h), k), m), n) und o) jeweils aufeinander folgen, insbesondere unter Auslassung der Schritte d), e) und/oder f) oder unter Einsatz von Schritt d) und unter Auslassung von Schritt e) und f), oder
dass die Schritte g), h), i), k), m), n) und o) jeweils aufeinander folgen, insbesondere unter Auslassung der Schritte d), e) und/oder f) oder unter Einsatz von Schritt d) und unter Auslassung von Schritt e) und f), oder
dass die Schritte d), e), f), k), m), n) und o) jeweils aufeinander folgen oder
dass die Schritte d), e), f), i), k), m), n) und o) jeweils aufeinander folgen oder
dass die Schritte d), e), f), g), k), m), n) und o) jeweils aufeinander folgen oder
dass die Schritte d), e), f), g), i), k), m), n) und o) jeweils aufeinander folgen.

3. Verfahren zur Herstellung eines beschichteten Metallsubstrats, umfassend
A) Zurverfügungstellung eines Metallsubstrats mit mindestens einer zumindest bereichsweise beschichtbaren Oberfläche,
B) Zurverfügungstellung einer Applikationsanlage für die Aufbringung einer Metallschicht,
C) Zurverfügungstellung mindestens eines Plasmagenerator und/oder mindestens einer Corona-Anlage,
D) gegebenenfalls Reinigung des Metallsubstrats oder der beschichtbaren Oberfläche des Metallsubstrats,
E) gegebenenfalls Aufbringen mindestens einer Metallschicht, enthaltend oder bestehend aus einem zweiten Metall ausgewählt aus der Gruppe bestehend aus Titan, Hafnium und Zirkonium, oder aus einer zweiten Metalllegierung ausgewählt aus der Gruppe bestehend aus Titan-, Hafnium- und Zirkoniumlegierungen, mit der Applikationsanlage auf das Metallsubstrat oder die beschichtbare Oberfläche des Metallsubstrats gemäß Schritt A) oder D),
F) gegebenenfalls Plasmabehandlung mit dem Plasmagenerator und/oder Corona-Behandlung des Metallsubstrats oder der beschichtbaren Oberfläche des Metallsubstrats gemäß Schritt A) oder D) oder der Metallschicht gemäß Schritt E),
G) gegebenenfalls Behandeln des nach Schritt A) oder D) erhaltenen Metallsubstrats oder Behandeln der nach Schritt A) oder D) erhaltenen beschichtbaren Oberfläche des Metallsubstrats oder der nach Schritt E) oder F) erhaltenen Metallschicht mit mindestens einer siliziumorganischen Verbindung unter Ausbildung einer Polysiloxanschicht,
H) gegebenenfalls Plasmabehandlung mit dem Plasmagenerator und/oder Corona-Behandlung der Polysiloxanschicht gemäß Schritt G),
I) gegebenenfalls Aufbringen einer Konversiartssehicht auf das Metallsubstrat oder die beschichtbare Oberfläche des Metallsubstrats gemäß Schritt A) oder D) oder auf die Metallschicht gemäß Schritt E) oder F) oder auf die Polysiloxanschicht gemäß Schritt G) oder H),
J) gegebenenfalls Plasmabehandlung mit dem Plasmagenerator und/oder Corona-Behandlung der Konversionsschicht gemäß Schritt I),
K) gegebenenfalls Behandeln der nach Schritt I) oder J) erhaltenen Konversionsschicht mit mindestens einer siliziumorganischen Verbindung unter Ausbildung einer Polysiloxanschicht,
L) gegebenenfalls Plasmabehandlung mit dem Plasmagenerator und/oder Corona-Behandlung der nach Schritt K) erhaltenen behandelten Polysiloxanschicht,
M) gegebenenfalls Aufbringen mindestens einer Grundierungsschicht auf das Metallsubstrat oder die beschichtbare Oberfläche des Metallsubstrats gemäß Schritt A) oder D) oder auf die Metallschicht gemäß Schritt E) oder F) oder auf die Polysiloxanschicht gemäß Schritt G) oder H) oder auf die Konversionsschicht gemäß Schritt I) oder J) oder auf die Polysiloxanschicht gemäß Schritt K) oder L),
N) gegebenenfalls Plasmabehandlung mit dem Plasmagenerator und/oder Corona-Behandlung der Grundierungsschicht gemäß Schritt M),
O) gegebenenfalls Behandeln der nach Schritt M) oder N) erhaltenen Grundierungsschicht mit mindestens einer siliziumorganischen Verbindung unter Ausbildung einer Polysiloxanschicht,
P) gegebenenfalls Plasmabehandlung mit dem Plasmagenerator und/oder Corona-Behandlung der nach Schritt O) erhaltenen behandelten Polysiloxanschicht,
Q) Aufbringen mindestens einer Metallschicht, enthaltend oder bestehend aus einem ersten Metall ausgewählt aus der Gruppe bestehend aus Aluminium, Silber, Gold, Blei, Vanadium, Mangan, Magnesium, Eisen, Kobalt, Molybdän, Wolfram, Nickel, Kupfer, Chrom, Palladium, Platin, Titan, Zirkonium und Zink oder enthaltend oder bestehend aus einer ersten Metalllegierung ausgewählt aus der Gruppe bestehend aus Messing, Bronze, Stahl, Aluminium-, Magnesium- und Titanlegierungen, mit der Applikationsanlage, auf das Metallsubstrat oder die beschichtbare Oberfläche des Metallsubstrats gemäß Schritt A) oder D) oder auf die Metallschicht gemäß Schritt E) oder F) oder auf die Polysiloxanschicht gemäß Schritt G) oder H) oder auf die Konversionsschicht gemäß Schritt I) oder J) oder auf die Polysiloxanschicht gemäß Schritt K) oder L) oder auf die Grundierungsschicht gemäß Schritt M) oder N) oder auf die Polysiloxanschicht gemäß Schritt O) oder P),
R) gegebenenfalls Plasmabehandlung mit dem Plasmagenerator und/oder Corona-Behandlung der Metallschicht gemäß Schritt Q),
S) Behandeln der nach Schritt Q) oder R) erhaltenen Metallschicht mit mindestens einer siliziumorganischen Verbindung unter Ausbildung einer Polysiloxanschicht,
T) Plasmabehandlung mit dem Plasmagenerator und/oder Corona-Behandlung der Polysiloxanschicht gemäß Schritt S) und
U) Auftragen einer Deckschicht auf die behandelte Polysiloxanschicht gemäß Schritt T).

4. Verfahren nach Anspruch 3, **dadurch gekennzeichnet, dass**
die Schritte D), M), N), Q), S), T) und U) jeweils aufeinander folgen oder
dass die Schritte D), M), N), O), Q), S), T) und U) jeweils aufeinander folgen oder
dass die Schritte D), E), F,), M), Q), S), T) und U) jeweils aufeinander folgen oder
dass die Schritte D), E), F,), M), O), Q), S), T) und U) jeweils aufeinander folgen oder
dass die Schritte D), G), H), M), Q), S), T) und U) jeweils aufeinander folgen oder
dass die Schritte D), G), H), M), O), Q), S), T) und U) jeweils aufeinander folgen oder
dass die Schritte D), E), G), H), M), Q), S), T) und U) jeweils aufeinander folgen oder
dass die Schritte D), E), G), H), M), O), Q), S), T) und U) jeweils aufeinander folgen oder
dass die Schritte D), M), Q), S), T) und U) jeweils aufeinander folgen oder
dass die Schritte D), M), O), Q), S), T) und U) jeweils aufeinander folgen oder
dass die Schritte D), G), H), Q), S), T) und U) jeweils aufeinander folgen oder
dass die Schritte D), G), H), O), Q), S), T) und U) jeweils aufeinander folgen.

5. Verfahren nach einem oder mehreren der vorangehenden Ansprüche, **dadurch gekennzeichnet, dass**
das Metallsubstrat Metalle oder Metalllegierungen umfasst oder hieraus besteht oder dass das nicht-metallische Substrat Glas, Keramik, Verbundfasermaterialien, Carbonmaterialien, Kunststoff oder Holz umfasst oder hieraus besteht.

6. Verfahren nach Anspruch 3 oder nach einem der Ansprüche 4 oder 5, sofern und soweit direkt oder indirekt auf Anspruch 3 rückbezogen, **dadurch gekennzeichnet, dass**
das Metallsubstrat ausgewählt ist aus der Gruppe bestehend aus Aluminium, Aluminiumlegierungen, Eisen, Eisenlegierungen, insbesondere Stahl oder Edelstahl, Kupfer, Kupferlegierungen, Titan, Titanlegierungen, Zink, Zinklegierungen, Nickel, Nicklegierungen, Molybdän, Molybdänlegierungen, Magnesium, Magnesiumlegierungen, Blei, Bleilegierungen, Wolfram, Wolframlegierungen, Mangan, Manganlegierungen, Messing, Bronze, Nickeldruckguss, Zinkdruckguss und Aluminiumdruckguss oder deren beliebigen Mischungen.

7. Verfahren nach einem oder mehreren der vorangehenden Ansprüche, **dadurch gekennzeichnet, dass**
die siliziumorganische Verbindung mindestens ein aminohaltiges Silan umfasst.

8. Verfahren nach einem oder mehreren der vorangehenden Ansprüche, **dadurch gekennzeichnet, dass**
der Schritt der Plasmabehandlung mit dem Plasmagenerator
- unter Einsatz von mindestens einem Inertgas oder
- unter Einsatz von mindestens einem Inertgas und Sauerstoff, Stickstoff, Kohlendioxid, Wasserstoff, Kohlenmonoxid, Wasserstoffperoxidgas, Wasserdampf, Ozon und/oder Luft oder
- unter Einsatz von Sauerstoff, Stickstoff, Wasserstoff, Kohlendioxid, Kohlenmonoxid, Wasserstoffperoxidgas, Wasserdampf, Ozon und/oder Luft, vorzugsweise unter Ausschluss von Inertgasen,
durchgeführt wird.

9. Verfahren nach einem oder mehreren der vorangehenden Ansprüche, **dadurch gekennzeichnet, dass**
die Plasmabehandlung mit dem Plasmagenerator und/oder die Aufbringung der Metallschicht und/oder die Aufbringung der Polysiloxanschicht in der Applikationsanlage für die Aufbringung einer Metallschicht vorgenommen wird.

10. Verfahren nach einem oder mehreren der vorangehenden Ansprüche, **dadurch gekennzeichnet, dass**
die Deckschicht Polyacrylatharze, Polyesterharze, Aminoplastharze oder Polyurethanverbindungen umfasst oder hieraus besteht und/oder dass die Deckschicht aus einem UV-härtenden Beschichtungsmaterial oder aus einem 1K- oder 2K-Einbrennlack gebildet ist, insbesondere eine UV-gehärtete Deckschicht oder eine 1K- oder 2K-Einbrennlack-Deckschicht darstellt.

11. Verfahren nach einem oder mehreren der vorangehenden Ansprüche, **dadurch gekennzeichnet, dass**
die Metallschicht mittels Physical Vapour Deposition (PVD), Chemical Vapour Deposition (CVD), Aufdampfen mittels eines Elektronenstahl-Verdampfers, Aufdampfen mittels eines Widerstandsverdampfers, Induktionsverdampfung, ARC-Verdampfung oder Kathoden- bzw. Anodenzerstäubung (Sputter-Beschichtung) aufgebracht wird.

12. Verfahren nach Anspruch 3 oder nach einem oder mehreren der Ansprüche 4 bis 11, sofern und soweit direkt oder indirekt auf Anspruch 3 rückbezogen, **dadurch gekennzeichnet, dass**
die Reinigung des Metallsubstrats gemäß Schritt D) das Entfetten, Dekapieren, Phosphatieren. Polieren, Schleifen und/oder Behandeln mit Trockeneis umfasst.

13. Verfahren nach einem oder mehreren der vorangehenden Ansprüche, **dadurch gekennzeichnet, dass**
in dem Schritt der Aufbringung der Metallschicht ein erstes Metall oder eine erste Metalllegierung in der Applikationsanlage für die Aufbringung einer Metallschicht zeitlich überlappend mit einem zweiten Metall oder mit einer zweiten Metalllegierung co-verdampft wird.

14. Verfahren nach einem oder mehreren der vorangehenden Ansprüche, **dadurch gekennzeichnet, dass**
eine erste siliziumorganische Verbindung über eine Zuführleitung aus einem außerhalb der Applikationsanlage für die Aufbringung einer Metallschicht befindlichen ersten Behältnis dieser Applikationsanlage zugeführt wird und dass eine zweite siliziumorganische Verbindung über eine Zuführleitung aus einem außerhalb der Applikationsanlage für die Aufbringung einer Metallschicht befindlichen zweiten Behältnis dieser Applikationsanlage zugeführt wird.

15. Verfahren nach einem oder mehreren der vorangehenden Ansprüche, **dadurch gekennzeichnet, dass**
man gemeinsam mit der mindestens einen siliziumorganischen Verbindung mindestens ein Farbmittel in die Applikationsanlage für die Aufbringung einer Metallschicht einbringt und/oder dass
für das Auftragen der Deckschicht ein Beschichtungsmaterial enthaltend mindestens ein Farbmittel eingesetzt wird.

16. Verfahren nach einem oder mehreren der vorangehenden Ansprüche, **dadurch gekennzeichnet, dass**
der Schritt der Behandlung mit mindestens einer siliziumorganischen Verbindung unter Ausbildung einer Polysiloxanschicht in Gegenwart mindestens eines reaktiven Gases, insbesondere ausgewählt aus der Gruppe bestehend aus Sauerstoff, Stickstoff, Kohlendioxid, Wasserstoff, Kohlenmonoxid, Wasserstoffperoxidgas, Wasserdampf, Ozon, Luft und deren Mischungen durchgeführt wird.

17. Verfahren nach Anspruch 16, **dadurch gekennzeichnet, dass**
die mindestens eine siliziumorganische Verbindung und das mindestens eine reaktive Gas als Mischung für den Behandlungsschritt eingesetzt werden.

18. Verfahren nach Anspruch 16 oder 17, **dadurch gekennzeichnet, dass**
der Schritt der Behandlung mit mindestens einer siliziumorganischen Verbindung unter Ausbildung einer Polysiloxanschicht in Gegenwart mindestens eines reaktiven Gases mindestens für einen Schritt zur Herstellung einer Polysiloxanschicht oder für jeden Schritt zur Herstellung einer Polysiloxanschicht eingesetzt wird, insbesondere für Schritt m) oder für Schritt S).

19. Verfahren nach einem oder mehreren der vorangehenden Ansprüche, **dadurch gekennzeichnet, dass**
das nicht-metallische Substrat ein Kunststoffsubstrat und/oder die Applikationsanlage für die Aufbringung einer Metallschicht eine Vakuumaufdampfanlage oder Sputter-Anlage darstellt und/oder dass das erste Metall Aluminium und/oder die erste Metalllegierung eine Aluminiumlegierung ist.

20. Verfahren nach einem oder mehreren der vorangehenden Ansprüche, **dadurch gekennzeichnet, dass**
der mindestens eine Plasmagenerator und/oder die mindesten eine Corona-Anlage in der Applikationsanlage für die Aufbringung einer Metallschicht oder als Bestandteil hiervon zur Verfügung gestellt wird.

21. Verfahren nach einem oder mehreren der vorangehenden Ansprüche, **dadurch gekennzeichnet, dass**
die mindestens eine siliziumorganische Verbindung mittels Plasmapolysrierisation eine Polysiloxanschicht ausbildet.

22. Verfahren nach einem oder mehreren der vorangehenden Ansprüche, **dadurch gekennzeichnet, dass**
die mindestens eine Metallschicht mittels Aufdampf- und/oder Sputter-Technik aufgebracht wird.

23. Verfahren nach einem oder mehreren der vorangehenden Ansprüche, **dadurch gekennzeichnet, dass**
die Deckschicht transparent ist.

24. Verfahren nach einem oder mehreren der Ansprüche 2 oder 4 oder 5 bis 23, sofern und soweit direkt oder indirekt auf Anspruch 2 oder 4 rückbezogen, **dadurch gekennzeichnet, dass** die Schritte der jeweiligen Verfahrenssequenzen unmittelbar aufeinander folgen.

25. Verfahren nach einem oder mehreren der Ansprüche 7 bis 24, **dadurch gekennzeichnet, dass**
das aminohaltige Silan Amino-propyltrietlioxysilan, Hexamethyldisiloxan, Tetramethyldisiloxan oder deren beliebige Mischungen umfasst.

26. Verfahren nach einem oder mehreren der Ansprüche 13 bis 25, **dadurch gekennzeichnet, dass**
das zweiten Metall ausgewählt ist aus der Gruppe bestehend aus Titan, Zirkonium und Hafnium, insbesondere Zirkonium, oder dass die zweite Metalllegierung ausgewählt aus der Gruppe bestehend aus Titan-, Zirkonium- und Hafniumlegierungen.

27. Verfahren nach einem oder mehreren der Ansprüche 17 bis 26, **dadurch gekennzeichnet, dass**
die siliziumorganische Verbindung Hexamethyldisiloxan und das mindestens eine reaktive Gas Sauerstoff oder Luft darstellt.

## Claims

1. A method for manufacturing a coated non-metal substrate, involving
a) providing a non-metal substrate with at least one surface which can be coated at least in certain areas,
b) providing an application system for applying a metal layer,
c) providing at least one plasma generator and/or at least one corona system,
d) optionally, plasma treatment using the plasma generator and/or corona treatment of the non-metal substrate or the coatable surface of the non-metal substrate,
e) optionally, treating the non-metal substrate obtained according to step a) or d) or the coatable surface of the non-metal substrate with at least one organosilicon compound such that a polysiloxane layer is formed,
f) optionally, plasma treatment using the plasma generator and/or corona treatment of the polysiloxane layer according to step e),
g) optionally, applying at least one priming coat to the non-metal substrate or the coatable surface of the non-metal substrate according to step a) or d) or to the polysiloxane layer according to step e) or f),
h) optionally, plasma treatment using the plasma generator and/or corona treatment of the priming coat according to step g),
i) optionally, treating the priming coat obtained according to step g) or h) with at least one organosilicon compound such that a polysiloxane layer is formed,
j) optionally, plasma treatment using the plasma generator and/or corona treatment of the polysiloxane layer according to step i),
k) applying at least one metal layer containing or consisting of a first metal selected from the group consisting of aluminium, silver, gold, lead, vanadium, manganese, magnesium, iron, cobalt, nickel, copper, chrome, palladium, molybdenum, tungsten, platinum, titanium, zirconium and zinc or containing or consisting of a first metal alloy selected from the group consisting of brass, bronze, steel, or aluminium, magnesium and titanium alloys, using the application system, to the non-metal substrate or to the coatable surface of the non-metal substrate according to step a) or d) or to the polysiloxane layer according to step e) or f) or to the priming coat according to step g) or h) or to the polysiloxane layer according to step i) or j),
l) optionally, plasma treatment using the plasma generator and/or corona treatment of the metal layer according to step k),
m) treating the metal layer obtained according to step k) or 1) with at least one organosilicon compound such that a polysiloxane layer is formed,
n) plasma treatment using the plasma generator and/or corona treatment of the polysiloxane layer according to step m), and
o) applying an cover layer to the treated polysiloxane layer according to step n).

2. The method according to Claim 1, **characterized in that**
steps g), h), k), m), n) and o) each follow one another, in particular omitting steps d), e) and/or f) or using step d) and omitting step e) and f), or
that steps g), h), i), k), m), n) and o) each follow one another, in particular omitting steps d), e) and/or f) or using step d) and omitting step e) and f), or
that steps d), e), f), k), m), n) and o) each follow one another or
that steps d), e), f), i), k), m), n) and o) each follow one another or
that steps d), e), f), g), k), m), n) and o) each follow one another or
that steps d), e), f), g), i), k), m), n) and o) each follow one another.

3. A method for manufacturing a coated substrate, involving
A) providing a metal substrate with at least one surface which can be coated at least in certain areas,
B) providing an application system for applying a metal layer,
C) providing at least one plasma generator and/or at least one corona system,
D) optionally, cleaning the metal substrate or the coatable surface of the metal substrate,
E) optionally, applying at least one metal layer containing or consisting of a second metal selected from the group consisting of titanium, hafnium and zirconium, or a second metal alloy selected from the group consisting of titanium, hafnium and zirconium alloys, using the application system, to the metal substrate or the coatable surface of the metal substrate according to step A) or D),
F) optionally, plasma treatment using the plasma generator and/or corona treatment of the metal substrate or the coatable surface of the metal substrate according to step A) or D) or of the metal layer according to step E),
G) optionally, treating the metal substrate obtained according to step A) or D) or treating the coatable surface of the metal substrate obtained according to step A) or D) or the metal layer obtained according to step E) or F) with at least one organosilicon compound such that a polysiloxane layer is formed,
H) optionally, plasma treatment using the plasma generator and/or corona treatment of the polysiloxane layer according to step G),
I) optionally, applying a conversion layer to the metal substrate or the coatable surface of the metal substrate according to step A) or D) or to the metal layer according to step E) or F) or to the polysiloxane layer according to step G) or H),
J) optionally, plasma treatment using the plasma generator and/or corona treatment of the conversion layer according to step I),
K) optionally, treating the conversion layer obtained according to step I) or J) with at least one organosilicon compound such that a polysiloxane layer is formed,
L) optionally, plasma treatment using the plasma generator and/or corona treatment of the treated polysiloxane layer obtained according to step K),
M) optionally, applying at least one priming coat to the metal substrate or the coatable surface of the metal substrate according to step A) or D) or to the metal layer according to step E) or F) or to the polysiloxane layer according to step G) or H) or to the conversion layer according to step I) or J) or to the polysiloxane layer according to step K) or L),
N) optionally, plasma treatment using the plasma generator and/or corona treatment of the priming coat according to step M),
O) optionally, treating the priming coat obtained according to step M) or N) with at least one organosilicon compound such that a polysiloxane layer is formed,
P) optionally, plasma treatment using the plasma generator and/or corona treatment of the treated polysiloxane layer obtained according to step O),
Q) applying at least one metal layer containing or consisting of a first metal selected from the group consisting of aluminium, silver, gold, lead, vanadium, manganese, magnesium, iron, cobalt, molybdenum, tungsten, nickel, copper, chrome, palladium, platinum, titanium, zirconium and zinc or containing or consisting of a first metal alloy selected from the group consisting of brass, bronze, steel or aluminium, magnesium and titanium alloys, using the application system, to the metal substrate or the coatable surface of the metal substrate according to step A) or D) or to the metal layer according to step E) or F) or to the polysiloxane layer according to step G) or H) or to the conversion layer according to step I) or J) or to the polysiloxane layer according to step K) or L) or to the priming coat according to step M) or N) or to the polysiloxane layer according to step O) or P),
R) optionally, plasma treatment using the plasma generator and/or corona treatment of the metal layer according to step Q),
S) treating the metal layer obtained according to step Q) or R) with at least one organosilicon compound such that a polysiloxane layer is formed,
T) plasma treatment using the plasma generator and/or corona treatment of the polysiloxane layer according to step S), and
U) applying an cover layer to the treated polysiloxane layer according to step T).

4. The method according to Claim 3, **characterized in that**
steps D), M), N), Q), S), T) and U) each follow one another or
that steps D), M), N), O), Q), S), T) and U) each follow one another or
that steps D), E), F,), M), Q), S), T) and U) each follow one another or
that steps D), E), F,), M), O), Q), S), T) and U) each follow one another or
that steps D), G), H), M), Q), S), T) and U) each follow one another or
that steps D), G), H), M), O), Q), S), T) and U) each follow one another or
that steps D), E), G), H), M), Q), S), T) and U) each follow one another or
that steps D), E), G), H), M), O), Q), S), T) and U) each follow one another or
that steps D), M), Q), S), T) and U) each follow one another or
that steps D), M), O), Q), S), T) and U) each follow one another or
that steps D), G), H), Q), S), T) and U) each follow one another or
that steps D), G), H), O), Q), S), T) and U) each follow one another.

5. The method according to any one or more of the preceding claims, **characterized in that** the metal substrate comprises metals or metal alloys or consists thereof or that the non-metal substrate comprises glass, ceramic, composite fibre materials, carbon materials, plastic or wood or consists thereof.

6. The method according to Claim 3 or according to any one of Claims 4 or 5, if and when reference is made back directly or indirectly to Claim 3, **characterized in that**
the metal substrate is selected from the group consisting of aluminium, aluminium alloys, iron, iron alloys, in particular steel or stainless steel, copper, copper alloys, titanium, titanium alloys, zinc, zinc alloys, nickel, nickel alloys, molybdenum, molybdenum alloys, magnesium, magnesium alloys, lead, lead alloys, tungsten, tungsten alloys, manganese, manganese alloys, brass, bronze, die-cast nickel, die-cast zinc and die-cast aluminium or any mixtures thereof.

7. The method according to any one or more of the preceding claims, **characterized in that** the organosilicon compound comprises at least one amino-containing silane.

8. The method according to any one or more of the preceding claims, **characterized in that** the step of plasma treatment using the plasma generator is performed
- using at least one inert gas, or
- using at least one inert gas and oxygen, nitrogen, carbon dioxide, hydrogen, carbon monoxide, hydrogen peroxide gas, water vapour, ozone and/or air, or
- using oxygen, nitrogen, hydrogen, carbon dioxide, carbon monoxide, hydrogen peroxide gas, water vapour, ozone and/or air, preferably to the exclusion of inert gases.

9. The method according to any one or more of the preceding claims, **characterized in that** the plasma treatment using the plasma generator and/or the application of the metal layer and/or the application of the polysiloxane layer is/are carried out in the application system for applying a metal layer.

10. The method according to any one or more of the preceding claims, **characterized in that**
the cover layer comprises polyacrylate resins, polyester resins, aminoplast resins or polyurethane compounds or consists thereof, and/or that the cover layer is formed from a UV-curable coating material or from a 1K or 2K stove enamel, in particular constitutes a UV-curable cover layer or a 1K or 2K stove enamel cover layer.

11. The method according to any one or more of the preceding claims, **characterized in that**
the metal layer is applied by means of physical vapour deposition (PVD), chemical vapour deposition (CVD), vapour deposition using an electron beam vaporizer, vapour deposition using a resistance vaporizer, induction vaporization, ARC vaporization or cathode or anode spraying (sputter coating).

12. The method according to Claim 3 or according to any one or more of Claims 4 to 11, if and when reference is made back directly or indirectly to Claim 3,
**characterized in that**
the cleaning of the metal substrate according to step D) comprises degreasing, pickling, phosphating, polishing, grinding and/or treating with dry ice.

13. The method according to any one or more of the preceding claims, **characterized in that**
during the step of applying the metal layer a first metal or a first metal alloy is co-evaporated in the application system for applying a metal layer with a second metal or with a second metal alloy such that these overlap in time.

14. The method according to any one or more of the preceding claims, **characterized in that**
a first organosilicon compound is supplied by means of a supply line from a first container located outside the application system for applying a metal layer to said application system, and that a second organosilicon compound is supplied by means of a supply line from a second container located outside the application system for applying a metal layer to said application system.

15. The method according to any one or more of the preceding claims, **characterized in that**
at least one colorant is introduced into the application system for applying a metal layer together with the at least one organosilicon compound, and/or that a coating material containing at least one colorant is used for applying the cover layer.

16. The method according to any one or more of the preceding claims, **characterized in that**
the step involving treatment with at least one organosilicon compound such that a polysiloxane layer is formed is performed in the presence of at least one reactive gas, in particular selected from the group consisting of oxygen, nitrogen, carbon dioxide, hydrogen, carbon monoxide, hydrogen peroxide gas, water vapour, ozone, air and mixtures thereof.

17. The method according to Claim 16, **characterized in that**
the at least one organosilicon compound and the at least one reactive gas are used as a mixture for the treatment step.

18. The method according to Claim 16 or 17, **characterized in that**
the step involving treatment with at least one organosilicon compound such that a polysiloxane layer is formed in the presence of at least one reactive gas is used at least for one step for manufacturing a polysiloxane layer or for each step for manufacturing a polysiloxane layer, in particular for step m) or for step S).

19. The method according to any one or more of the preceding claims, **characterized in that**
the non-metal substrate constitutes a plastic substrate and/or the application system for applying a metal layer constitutes a vacuum vapour deposition system or sputter system and/or that the first metal is aluminium and/or the first metal alloy is an aluminium alloy.

20. The method according to any one or more of the preceding claims, **characterized in that**
the at least one plasma generator and/or the at least one corona system is/are provided in the application system for applying a metal layer or as a component hereof.

21. The method according to any one or more of the preceding claims, **characterized in that**
the at least one organosilicon compound forms a polysiloxane layer by means of plasma polymerization.

22. The method according to any one or more of the preceding claims, **characterized in that**
the at least one metal layer is applied by means of vapour deposition and/or sputter technology.

23. The method according to any one or more of the preceding claims, **characterized in that** the cover layer is transparent.

24. The method according to any one or more of Claims 2 or 4 or 5 to 23, if and when reference is made back directly or indirectly to Claim 2 or 4, **characterized in that** the steps of the respective method sequences directly follow one another.

25. The method according to any one or more of Claims 7 to 24, **characterized in that**
the amino-containing silane comprises aminopropyltriethoxysilane, hexamethyldisiloxane, tetramethyldisiloxane or any mixtures thereof.

26. The method according to any one or more of Claims 13 to 25, **characterized in that**
the second metal is selected from the group consisting of titanium, zirconium and hafnium, in particular zirconium, or that the second metal alloy is selected from the group consisting of titanium, zirconium and hafnium alloys.

27. The method according to any one or more of Claims 17 to 26, **characterized in that**
the organosilicon compound constitutes hexamethyldisiloxane and the at least one reactive gas constitutes oxygen or air.

## Revendications

1. Procédé de fabrication d'un substrat non métallique revêtu comprenant
a) préparation d'un substrat non métallique avec au moins une surface pouvant être au moins partiellement revêtue,
b) préparation d'une installation d'application pour l'application d'une couche métallique,
c) préparation d'au moins un générateur de plasma et/ou d'au moins une installation à effet corona,
d) le cas échéant, traitement par plasma avec le générateur de plasma et/ou traitement à effet corona du substrat non métallique ou de la surface du substrat non métallique pouvant être revêtue,
e) le cas échéant, traitement du substrat non métallique obtenu suivant l'étape a) ou d) ou de la surface du substrat non métallique pouvant être revêtue avec au moins un composé organosilicié en formant une couche polysiloxane,
f) le cas échéant, traitement par plasma avec le générateur de plasma et/ou traitement à effet corona de la couche polysiloxane conformément à l'étape e),
g) le cas échéant, application d'au moins une couche primaire sur le substrat non métallique ou la surface du substrat non métallique pouvant être revêtue conformément à l'étape a) ou d) ou sur la couche polysiloxane conformément à l'étape e) ou f),
h) le cas échéant, traitement par plasma avec le générateur de plasma et/ou traitement à effet corona de la couche primaire conformément à l'étape g),
i) le cas échéant, traitement de la couche primaire obtenue suivant l'étape g) ou h) avec au moins un composé organosilicié en formant une couche polysiloxane,
j) le cas échéant, traitement par plasma avec le générateur de plasma et/ou traitement à effet corona de la couche polysiloxane conformément à l'étape i),
k) application d'au moins une couche métallique, contenant ou composée d'un premier métal sélectionné dans le groupe comprenant aluminium, argent, or, plomb, vanadium, manganèse, magnésium, fer, cobalt, nickel, cuivre, chrome, palladium, molybdène, tungstène, platine, titane, zirconium et zinc, ou contenant ou composée d'un premier alliage métallique sélectionné dans le groupe comprenant laiton, bronze, acier, alliages d'aluminium, de magnésium et de titane, avec l'installation d'application sur le substrat non métallique ou sur la surface du substrat non métallique pouvant être revêtue conformément à l'étape a) ou d) ou sur la couche polysiloxane conformément à l'étape e) ou f) ou sur la couche primaire conformément à l'étape g) ou h) ou sur la couche polysiloxane conformément à l'étape i) ou j),
l) le cas échéant, traitement par plasma avec le générateur de plasma et/ou traitement à effet corona de la couche métallique conformément à l'étape k),
m) traitement de la couche métallique obtenue suivant l'étape k) ou 1) avec au moins un composé organosilicié en formant une couche polysiloxane,
n) traitement par plasma avec le générateur de plasma et/ou traitement à effet corona de la couche polysiloxane conformément à l'étape m) et
o) application d'une couche de couverture sur la couche polysiloxane traitée conformément à l'étape n).

2. Procédé selon la revendication 1, **caractérisé en ce que**
les étapes g), h), k), m), n) et o) se succèdent, en particulier en omettant les étapes d), e) et/ou f) ou en mettant en oeuvre l'étape d) et en omettant l'étape e) et f), ou
**en ce que** les étapes g), h), i), k), m), n) et o) se succèdent, en particulier en omettant les étapes d), e) et/ou f) ou en mettant en oeuvre l'étape d) et en omettant les étapes e) et f), ou
**en ce que** les étapes d), e), f), k), m), n) et o) se succèdent, ou
**en ce que** les étapes d), e), f), i), k), m), n) et o) se succèdent, ou
**en ce que** les étapes d), e), f), g), k), m), n) et o) se succèdent, ou
**en ce que** les étapes d), e), f), g), i), k), m), n) et o) se succèdent.

3. Procédé de fabrication d'un substrat métallique revêtu, comprenant
A) préparation d'un substrat métallique avec au moins une surface pouvant être au moins partiellement revêtue,
B) préparation d'une installation d'application pour l'application d'une couche métallique,
C) préparation d'au moins un générateur de plasma et/ou d'au moins une installation à effet corona,
D) le cas échéant, nettoyage du substrat métallique ou de la surface du substrat métallique pouvant être revêtue,
E) le cas échéant, application d'au moins une couche métallique, contenant ou composée d'un deuxième métal sélectionné dans le groupe comprenant titane, hafnium et zirconium, ou d'un deuxième alliage métallique sélectionné dans le groupe comprenant des alliages de titane, d'hafnium et de zirconium, avec l'installation d'application sur le substrat métallique ou la surface du substrat métallique pouvant être revêtue conformément à l'étape A) ou D),
F) le cas échéant, traitement par plasma avec le générateur de plasma et/ou traitement à effet corona du substrat métallique ou de la surface du substrat métallique pouvant être revêtue conformément à l'étape A) ou D) ou de la couche métallique conformément à l'étape E),
G) le cas échéant, traitement du substrat métallique obtenu suivant l'étape A) ou D) ou traitement de la surface du substrat métallique pouvant être revêtue obtenue suivant l'étape A) ou D) ou de la couche métallique obtenue suivant l'étape E) ou F) avec au moins un composé organosilicié en formant une couche polysiloxane,
H) le cas échéant, traitement par plasma avec le générateur de plasma et/ou traitement à effet corona de la couche polysiloxane conformément à l'étape G),
I) le cas échéant, application d'une couche de conversion sur le substrat métallique ou la surface du substrat métallique pouvant être revêtue conformément à l'étape A) ou D) ou sur la couche métallique conformément à l'étape E) ou F) ou sur la couche polysiloxane conformément à l'étape G) ou H),
J) le cas échéant, traitement par plasma avec le générateur de plasma et/ou traitement à effet corona de la couche de conversion conformément à l'étape I),
K) le cas échéant, traitement de la couche de conversion obtenue suivant l'étape I) ou J) avec au moins un composé organosilicié en formant une couche polysiloxane,
L) le cas échéant, traitement par plasma avec le générateur de plasma et/ou traitement à effet corona de la couche polysiloxane obtenue suivant l'étape K),
M) le cas échéant, application d'au moins une couche primaire sur le substrat métallique ou la surface du substrat métallique pouvant être revêtue conformément à l'étape A) ou D) ou sur la couche métallique conformément à l'étape E) ou F) ou sur la couche polysiloxane conformément à l'étape G) ou H) ou sur la couche de conversion conformément à l'étape 1) ou J) ou sur la couche polysiloxane conformément à l'étape K) ou L),
N) le cas échéant, traitement par plasma avec le générateur de plasma et/ou traitement à effet corona de la couche primaire conformément à l'étape M),
O) le cas échéant, traitement de la couche primaire obtenue suivant l'étape M) ou N) avec au moins un composé organosilicié en formant une couche polysiloxane,
P) le cas échéant, traitement par plasma avec le générateur de plasma et/ou traitement à effet corona de la couche polysiloxane traitée obtenue suivant l'étape O),
Q) application d'au moins une couche métallique, contenant ou composée d'un premier métal sélectionné dans le groupe comprenant aluminium, argent, or, plomb, vanadium, manganèse, magnésium, fer, cobalt, molybdène, tungstène, nickel, cuivre, chrome, palladium, platine, titane, zirconium et zinc, ou contenant ou composée d'un premier alliage métallique sélectionné dans le groupe comprenant laiton, bronze, acier, alliages d'aluminium, de magnésium et de titane, avec l'installation d'application, sur le substrat métallique ou la surface du substrat métallique pouvant être revêtue conformément à l'étape A) ou D) ou sur la couche métallique conformément à l'étape E) ou F) ou sur la couche polysiloxane conformément à l'étape G) ou H) ou sur la couche de conversion conformément à l'étape 1) ou J) ou sur la couche polysiloxane conformément à l'étape K) ou L) ou sur la couche primaire conformément à l'étape M) ou N) ou sur la couche polysiloxane conformément à l'étape O) ou P),
R) le cas échéant, traitement par plasma avec le générateur de plasma et/ou traitement à effet corona de la couche métallique conformément à l'étape Q),
S) traitement de la couche métallique obtenue suivant l'étape Q) ou R) avec au moins un composé organosilicié en formant une couche polysiloxane,
T) traitement par plasma avec le générateur de plasma et/ou traitement à effet corona de la couche polysiloxane conformément à l'étape S) et
U) application d'une couche de couverture sur la couche polysiloxane traitée conformément à l'étape T).

4. Procédé selon la revendication 3, **caractérisé en ce que**
les étapes D), M), N), Q), S), T) et U) se succèdent, ou
**en ce que** les étapes D), M), N), O), Q), S), T) et U) se succèdent, ou
**en ce que** les étapes D), E), F,), M), Q), S), T) et U) se succèdent, ou
**en ce que** les étapes D), E), F,), M), O), Q), S), T) et U) se succèdent, ou
**en ce que** les étapes D), G), H), M), Q), S), T) et U) se succèdent, ou
**en ce que** les étapes D), G), H), M), O), Q), S), T) et U) se succèdent, ou
**en ce que** les étapes D), E), G), H), M), Q), S), T) et U) se succèdent, ou
**en ce que** les étapes D), E), G), H), M), O), Q), 5), T) et U) se succèdent, ou
**en ce que** les étapes D), M), Q), S), T) et U) se succèdent, ou
**en ce que** les étapes D), M), O), Q), S), T) et U) se succèdent, ou
**en ce que** les étapes D), G), H), Q), S), T) et U) se succèdent, ou
**en ce que** les étapes D), G), H), O), Q), S), T) et U) se succèdent.

5. Procédé selon l'une ou plusieurs des revendications précédentes, **caractérisé en ce que** le substrat métallique comprend des métaux ou des alliages métalliques ou est composé de ceux-ci ou **en ce que** le substrat non métallique comprend verre, céramique, matériaux fibreux composites, matériaux carbone, matière plastique ou bois ou est composé de ceux-ci.

6. Procédé selon la revendication 3 ou selon la revendication 4 ou la revendication 5, si dépendante directement ou indirectement de la revendication 3, **caractérisé en ce que** le substrat métallique est sélectionné dans le groupe comprenant aluminium, alliages d'aluminium, fer, alliages de fer, en particulier acier ou acier inoxydable, cuivre, alliages de cuivre, titane, alliages de titane, zinc, alliages de zinc, nickel, alliages de nickel, molybdène, alliages de molybdène, magnésium, alliages de magnésium, plomb, alliages de plomb, tungstène, alliages de tungstène, manganèse, alliages de manganèse, laiton, bronze, nickel moulé, zinc moulé et aluminium moulé ou des mélanges quelconques de ceux-ci.

7. Procédé selon l'une ou plusieurs des revendications précédentes, **caractérisé en ce que** le composé organosilicié comprend au moins un silane aminé.

8. Procédé selon l'une ou plusieurs des revendications précédentes, **caractérisé en ce que** l'étape de traitement par plasma avec le générateur de plasma est exécutée
- en mettant en oeuvre au moins un gaz inerte, ou
- en mettant en oeuvre au moins un gaz inerte et de l'oxygène, de l'azote, du dioxyde de carbone, de l'hydrogène, du monoxyde de carbone, de la vapeur de peroxyde d'hydrogène, de la vapeur d'eau, de l'ozone et/ou de l'air, ou
- en mettant en oeuvre de l'oxygène, de l'azote, du dioxyde de carbone, du monoxyde de carbone, de la vapeur de peroxyde d'hydrogène, de la vapeur d'eau, de l'ozone et/ou de l'air, préférentiellement en excluant les gaz inertes.

9. Procédé selon l'une ou plusieurs des revendications précédentes, **caractérisé en ce que** le traitement par plasma avec le générateur de plasma et/ou l'application de la couche métallique et/ou l'application de la couche polysiloxane sont effectués dans l'instillation d'application pour l'application d'une couche métallique.

10. Procédé selon l'une ou plusieurs des revendications précédentes, **caractérisé en ce que** la couche de couverture comprend des résines polyacrylates, des résines polyesters, des résines aminoplastes ou des composés polyuréthanes ou est composée de ceux-ci et/ou **en ce que** la couche de couverture est formée d'un matériau de revêtement durcissable aux UV ou d'un vernis-émail à 1 ou 2 composants, et constitue en particulier une couche de couverture durcissable aux UV ou une couche de couverture en vernis-émail à 1 ou 2 composants.

11. Procédé selon l'une ou plusieurs des revendications précédentes, **caractérisé en ce que** la couche métallique est appliquée par dépôt physique en phase vapeur (PVD-Physical Vapour Deposition), dépôt chimique en phase vapeur (CVD-Chemical Vapour Deposition), vaporisation au moyen d'un évaporateur à faisceau d'électrons, vaporisation au moyen d'un évaporateur à résistance, vaporisation par induction, vaporisation par arc cathodique ou par vaporisation cathodique ou anodique (pulvérisation).

12. Procédé selon la revendication 3 ou selon l'une ou plusieurs des revendications 4 à 11, si dépendantes directement ou indirectement de la revendication 3, **caractérisé en ce que** le nettoyage du substrat métallique conformément à l'étape D) comprend le dégraissage, le décapage, le phosphatage, le polissage, la rectification et/ou le traitement par glace carbonique.

13. Procédé selon l'une ou plusieurs des revendications précédentes, **caractérisé en ce que** lors de l'étape d'application de la couche métallique, un premier métal ou un premier alliage métallique est co-évaporé dans l'installation d'application pour l'application d'une couche métallique en chevauchement temporel avec un deuxième métal ou avec un deuxième alliage métallique.

14. Procédé selon l'une ou plusieurs des revendications précédentes, **caractérisé en ce qu'**un premier composé organosilicié est amené à l'installation d'application pour l'application d'une couche métallique par une conduite d'amenée depuis un premier récipient extérieur à ladite installation d'application, et **en ce qu'**un deuxième composé organosilicié est amené à l'installation d'application pour l'application d'une couche métallique par une conduite d'amenée d'un deuxième récipient extérieur à ladite installation d'application.

15. Procédé selon l'une ou plusieurs des revendications précédentes, **caractérisé en ce qu'**on ajoute au moins un colorant avec ledit au moins un composé organosilicié dans l'installation d'application pour l'application d'une couche métallique et/ou **en ce qu'**un matériau de revêtement contenant au moins un colorant est mis en oeuvre pour l'application de la couche de couverture.

16. Procédé selon l'une ou plusieurs des revendications précédentes, **caractérisé en ce que** l'étape de traitement avec au moins un composé organosilicié en formant une couche polysiloxane est exécutée en présence d'au moins un gaz réactif, en particulier sélectionné dans le groupe comprenant oxygène, azote, dioxyde de carbone, hydrogène, monoxyde de carbone, vapeur de peroxyde d'hydrogène, vapeur d'eau, ozone, air et des mélanges de ceux-ci.

17. Procédé selon la revendication 16, **caractérisé en ce que**
ledit au moins un composé organosilicié et ledit au moins un gaz réactif sont mis en oeuvre en tant que mélange pour l'étape de traitement.

18. Procédé selon la revendication 16 ou 17, **caractérisé en ce que** l'étape de traitement avec au moins un composé organosilicié en formant une couche polysiloxane en présence d'au moins un gaz réactif est exécutée au moins pour une étape de production d'une couche polysiloxane ou pour chaque étape de production d'une couche polysiloxane, en particulier pour l'étape m) ou pour l'étape S).

19. Procédé selon l'une ou plusieurs des revendications précédentes, **caractérisé en ce que** le substrat non métallique est un substrat en matière plastique et/ou l'installation d'application pour l'application d'une couche métallique constitue une installation de vaporisation sous vide ou une installation de pulvérisation et/ou **en ce que** le premier métal est de l'aluminium et/ou le premier alliage métallique est un alliage d'aluminium.

20. Procédé selon l'une ou plusieurs des revendications précédentes, **caractérisé en ce que** ledit au moins un générateur de plasma et/ou ladite au moins une installation à effet corona sont préparés dans l'installation d'application pour l'application d'une couche métallique ou en tant qu'éléments intégrants de celle-ci.

21. Procédé selon l'une ou plusieurs des revendications précédentes, **caractérisé en ce que** ledit au moins un composé organosilicié forme une couche polysiloxane par polymérisation plasma.

22. Procédé selon l'une ou plusieurs des revendications précédentes, **caractérisé en ce que** ladite au moins une couche métallique est appliquée par vaporisation et/ou pulvérisation cathodique.

23. Procédé selon l'une ou plusieurs des revendications précédentes, **caractérisé en ce que** la couche de couverture est transparente.

24. Procédé selon l'une ou plusieurs des revendications 2 ou 4 ou 5 à 23, si dépendantes directement ou indirectement de la revendication 2 ou de la revendication 4, **caractérisé en ce que** les étapes des séquences de procédé respectives sont immédiatement successives.

25. Procédé selon l'une ou plusieurs des revendications 7 à 24, **caractérisé en ce que** le silane aminé comprend de l'aminopropyltriéthoxysilane, de l'hexaméthyldisiloxane, du tétraméthyldisiloxane ou des mélanges quelconques de ceux-ci.

26. Procédé selon l'une ou plusieurs des revendications 13 à 25, **caractérisé en ce que** le deuxième métal est sélectionné dans le groupe comprenant titane, zirconium et hafnium, en particulier du zirconium, ou **en ce que** le deuxième alliage métallique est sélectionné dans le groupe comprenant des alliages de titane, de zirconium et d'hafnium.

27. Procédé selon l'une ou plusieurs des revendications 17 à 26, **caractérisé en ce que** le composé organosilicié est de l'hexaméthyldisiloxane et ledit au moins un gaz réactif est de l'oxygène ou de l'air.
